(19) Europäisches Patentamt
European Patent Office
Office européen des brevets

(11) **EP 4 765 564 A1**

(12) **EUROPEAN PATENT APPLICATION**
published in accordance with Art. 153(4) EPC

(43) Date of publication:
**24.06.2026 Bulletin 2026/26**

(21) Application number: 25820371.0

(22) Date of filing: **21.05.2025**

(51) International Patent Classification (IPC):
*H02J 7/00* (2026.01)      *G01R 31/382* (2019.01)
*G01R 31/392* (2019.01)      *G01R 31/396* (2019.01)

(52) Cooperative Patent Classification (CPC):
G01R 31/382; G01R 31/392; G01R 31/396;
H02J 7/00

(86) International application number:
**PCT/KR2025/006888**

(87) International publication number:
**WO 2025/254367 (11.12.2025 Gazette 2025/50)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **04.06.2024 KR 20240073265**

(71) Applicant: **LG Energy Solution, Ltd.
Seoul 07335 (KR)**

(72) Inventors:
• **YU, Hye-In
Daejeon 34122 (KR)**
• **WHANG, Tae-Kyung
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **METHOD AND APPARATUS FOR GENERATING QUICK CHARGE MAP**

(57)     Provided are a method and apparatus for generating a quick charge map. The method for generating the quick charge map according to the present disclosure includes acquiring a plurality of charging test results respectively associated with a plurality of charging conditions according to a combination of a plurality of current rates and a plurality of ambient temperatures; determining a plurality of charging characteristic profiles respectively associated with the plurality of ambient temperatures by analyzing the plurality of charging test results; and determining a plurality of charging control profiles respectively associated with a plurality of temperatures of interest by analyzing the plurality of charging characteristic profiles, wherein the quick charge map is a set of the plurality of charging control profiles.

FIG. 22

EP 4 765 564 A1

## Description

### TECHNICAL FIELD

The present disclosure relates to generation of a quick charging control map for batteries.

This application is based on and claims priority to Korean Patent Application No. 10-2024-0073265 filed on June 4, 2024 in the Republic of Korea, the disclosure of which is incorporated herein by reference.

### BACKGROUND ART

Recently, there has been a rapid increase in the demand for portable electronic products such as laptop computers, video cameras and mobile phones, and with the extensive development of battery systems, accumulators for energy storage, robots and satellites, many studies are being made on high performance batteries that can be repeatedly charged and discharged.

Batteries on the market now include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

More recently, with the growing demand for high-capacity and high-output batteries, battery fast charging technologies are being proposed to shorten the charging time.

Charging batteries with excessively high current, voltage or power may cause irreversible damage to the batteries due to overheating.

To solve this problem, a quick charge map is required to adaptively adjust the charging intensity (for example, current rate) according to the state of battery (for example, state of charge (SOC)) that changes during charging.

The quick charge map is generally created under the assumption that battery temperature during charging is constantly maintained at battery temperature or ambient temperature at the start time of charging.

However, it takes a few tens of minutes to a few hours to fully charge the completely discharged battery, and the ambient temperature may irregularly change during charging. Moreover, even though the battery temperature and the ambient temperature are consistent with each other at the start time of charging, the battery temperature gradually rises during charging. As a result, even though the ambient temperature is kept constant, a difference between the battery temperature and the ambient temperature increases during charging. Accordingly, the use of the quick charge map created based on the ambient temperature does not ensure sufficient safety of battery fast charging.

### DISCLOSURE

#### Technical Problem

The present disclosure is designed to solve the above-described problems, and therefore the present disclosure is directed to providing a method and apparatus for generating a quick charge map as information that may be used to control the charging based on real-time battery temperature, rather than ambient temperature, by analyzing a plurality of charging test result information corresponding to a plurality of charging conditions with varying ambient temperatures.

These and other objectives and advantages of the present disclosure may be understood from the following description and will become apparent from the embodiments of the present disclosure. Also, it will be easily understood that the objectives and advantages of the present disclosure may be realized by the means set forth in the appended claims and a combination thereof.

#### Technical Solution

A method for generating a quick charge map according to an aspect of the present disclosure includes acquiring a plurality of charging test results respectively associated with a plurality of charging conditions according a combination of a plurality of current rates and a plurality of ambient temperatures; determining a plurality of charging characteristic profiles respectively associated with the plurality of ambient temperatures by analyzing the plurality of charging test results; and determining a plurality of charging control profiles respectively associated with a plurality of temperatures of interest by analyzing the plurality of charging characteristic profiles, wherein the quick charge map is a set of the plurality of charging control profiles.

A lowest ambient temperature of the plurality of ambient temperatures may be equal to or greater than a lower limit of a predetermined allowable temperature range. A highest ambient temperature of the plurality of ambient temperatures may be equal to or less than an upper limit of the allowable temperature range. A lowest current rate of the plurality of current rates may be equal to or greater than a lower limit of a predetermined allowable current range. A highest current rate of the plurality of current rates may be equal to or less than an upper limit of the allowable current range.

Each of the plurality of charging test results may indicate a depth of charge and a battery temperature of a battery when charging the battery in any one of the plurality of charging conditions. The depth of charge of each of the plurality of charging test results may indicate a maximum state of charge (SOC) of the battery at which the battery can be charged without lithium plating. The battery temperature of each of the plurality of charging test results may indicate a temperature of the battery at a timing corresponding to the depth of charge.

The determining of the plurality of charging characteristic profiles may include determining a plurality of charging test result sets by grouping the plurality of charging test results according to the plurality of ambient temperatures; and determining the plurality of charging characteristic profiles by applying a mathematical operation to the plurality of charging test result sets, respectively.

The mathematical operation may be curve fitting based on a polynomial having a predetermined highest degree.

Each of the plurality of charging characteristic profiles may indicate a three-dimensional relationship between a current rate, a depth of charge and a battery temperature according to any one of the plurality of ambient temperatures.

The determining of the plurality of charging control profiles may include performing on the plurality of temperatures of interest, respectively, the following steps of: when the plurality of charging characteristic profiles includes a predetermined number or more of charging characteristic profiles having a battery temperature range to which the temperature of interest belongs, determining a dataset of interest including the predetermined number or more of data points of interest having a same battery temperature as the temperature of interest from the predetermined number or more of charging characteristic profiles; and determining the charging control profile associated with the temperature of interest by applying a mathematical operation to the dataset of interest.

The mathematical operation may be curve fitting based on a polynomial having a predetermined highest degree.

The determining of the plurality of charging control profiles may include performing on the plurality of temperatures of interest, respectively, the following steps of: when the plurality of charging characteristic profiles includes less than a predetermined number of charging characteristic profiles having a battery temperature range to which the temperature of interest belongs, determining a curved surface function of interest by applying a mathematical operation to an extended dataset of interest including the charging test results of each charging characteristic profile having the battery temperature range to which the temperature of interest belongs and the charging test results of at least one charging characteristic profile having a battery temperature range to which the temperature of interest does not belong; and determining the charging control profile associated with the temperature of interest by using the temperature of interest as input to the curved surface function of interest.

Each of the plurality of charging control profiles may indicate a relationship between a current rate and a depth of charge according to any one of the plurality of temperatures of interest.

An apparatus for generating a quick charge map according to another aspect of the present disclosure includes a data input/output unit to acquire a plurality of charging test results respectively associated with a plurality of charging conditions according to a combination of a plurality of current rates and a plurality of ambient temperatures; and a processor to determine a plurality of charging characteristic profiles respectively associated with the plurality of ambient temperatures by analyzing the plurality of charging test results. The processor determines a plurality of charging control profiles respectively associated with a plurality of temperatures of interest by analyzing the plurality of charging characteristic profiles. The quick charge map is a set of the plurality of charging control profiles.

The processor may determine a plurality of charging test result sets by grouping the plurality of charging test results according to the plurality of ambient temperatures. The processor may determine the plurality of charging characteristic profiles by applying a mathematical operation to the plurality of charging test result sets, respectively.

The processor may determine the plurality of charging control profiles by performing a procedure on the plurality of temperatures of interest, respectively, the procedure including the operations of: when the plurality of charging characteristic profiles includes a predetermined number or more of charging characteristic profiles having a battery temperature range to which the temperature of interest belongs, determining a dataset of interest including the predetermined number or more of data points of interest having a same battery temperature as the temperature of interest from the predetermined number or more of charging characteristic profiles; and determining the charging control profile associated with the temperature of interest by applying a mathematical operation to the dataset of interest.

The processor may determine the plurality of charging control profiles by performing a procedure on the plurality of temperatures of interest, respectively, the procedure including the operations of: when the plurality of charging characteristic profiles includes less than a predetermined number of charging characteristic profiles having a battery temperature range to which the temperature of interest belongs, determining a curved surface function of interest by applying a mathematical operation to an extended dataset of interest including the charging test results of each charging characteristic profile having the battery temperature range to which the temperature of interest belongs and the charging test results of at least one charging characteristic profile having a battery temperature range to which the temperature of interest does not belong; and determining the charging control profile associated with the temperature of interest by using the temperature of interest as input to the curved surface function of interest.

A charging system according to still another aspect of the present disclosure includes the apparatus for generating the quick charge map.

Advantageous Effects

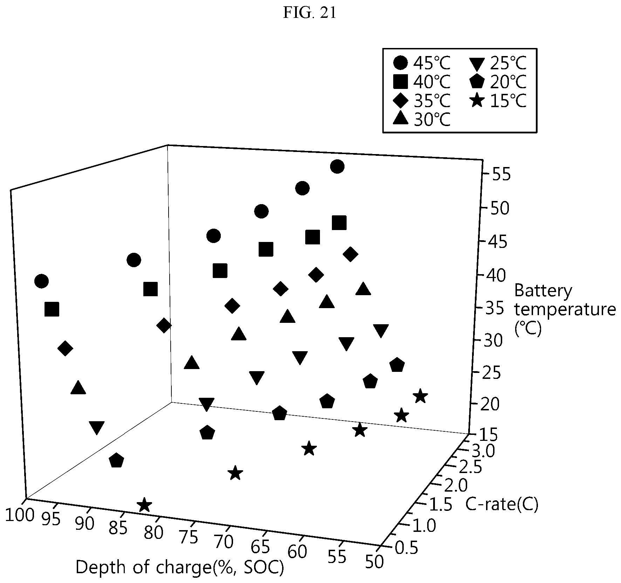

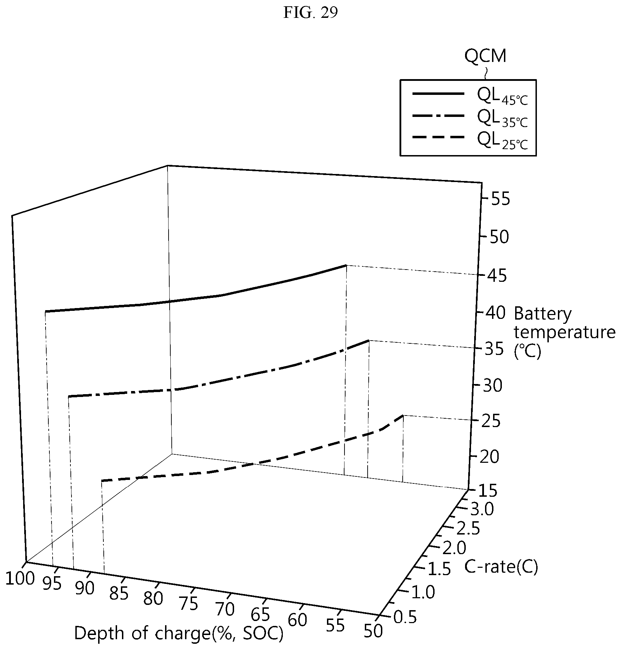

According to at least one of the embodiments of the present disclosure, the quick charge map (see FIG. 29) may be generated as information that may be used to control the charging based on real-time battery temperature, rather than ambient temperature, by analyzing the plurality of charging test result information (see FIG. 21) corresponding to the plurality of charging conditions with varying ambient temperatures. When the quick charge map generated according to the present disclosure is used, it may be possible to achieve charge control based on the actual temperature of the battery, thereby resolving the safety issue caused by extreme charging intensity.

The effects of the present disclosure are not limited to the aforementioned effects, and these and other effects will be clearly understood by those skilled in the art from the description of the claims.

BRIEF DESCRIPTION OF THE DRAWINGS

The accompanying drawings illustrate exemplary embodiments of the present disclosure and together with the following detailed description, serve to provide a better understanding of the technical aspects of the present disclosure, and thus the present disclosure should not be construed as being limited to the drawings.

FIG. 1 is a diagram exemplarily showing the architecture of a charging system according to the present disclosure.
FIGS. 2a and 2b are flowcharts exemplarily showing a charging test method according to a first embodiment of the present disclosure.
FIGS. 3 to 7 are diagrams referenced in describing the method of FIGS. 2a and 2b.
FIG. 8 is a flowchart exemplarily showing a charging test method according to a second embodiment of the present disclosure.
FIGS. 9 to 13 are graphs exemplarily showing resistance profiles referenced in describing the method of FIG. 8.
FIGS. 14 to 16 are diagrams referenced in describing a relationship between lithium plating and impedance during charging of a battery.
FIGS. 17 and 18 are diagrams exemplarily showing the structure of a test jig for a battery charging test.
FIGS. 19 and 20 are diagrams referenced in describing the results of a charging test using the test jig shown in FIGS. 17 and 18.
FIG. 21 is a three-dimensional graph exemplarily showing a plurality of charging test results according to a plurality of charging conditions.
FIG. 22 is a flowchart referenced in describing a method for generating a quick charge map according to an embodiment of the present disclosure by way of illustration.

FIG. 23 is a flowchart referenced in describing an example of subroutines that may be included in step S2320 of FIG. 22 by way of illustration.
FIG. 24 is a graph referenced in describing the method of FIG. 23.
FIGS. 25 and 26 are flowcharts referenced in describing an example of subroutines that may be included in step S2230 of FIG. 22 by way of illustration.
FIGS. 27 to 29 are graphs referenced in describing the method of FIGS. 25 and 26.

In certain drawings, the same reference numerals are affixed to the corresponding elements. Those skilled in the art will appreciate that the drawings depict the elements simply and clearly and are not necessarily drawn to scale. For example, to help a better understanding of various embodiments, some elements in the drawings may be depicted in exaggerated dimensions relative to other elements. Additionally, in certain commercially feasible embodiments, some useful or essential known elements may be omitted without departing from the principles of various embodiments of the present disclosure.

BEST MODE

Hereinafter, exemplary embodiments of the present disclosure will be described in detail with reference to the accompanying drawings. Prior to the description, it should be understood that the terms or words used in the specification and the appended claims should not be construed as being limited to general and dictionary meanings, and rather, should be interpreted based on the meanings and concepts corresponding to the technical aspects of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspects of the present disclosure but not intended to be limiting, so it should be understood that a variety of other equivalents and modifications could be made thereto at the time the application was filed.

The terms including the ordinal numbers such as "first", "second" and the like, are used to distinguish one element from another among various elements, but not intended to limit the elements by the terms.

Unless the context clearly indicates otherwise, the terms "comprise" and "include" when used in this specification, specify the presence of the stated elements, but do not preclude the presence or addition of one or more other elements. Additionally, the term "control unit" as used herein refers to a processing unit of at least one function or operation, and may be implemented by hardware and software either alone or in combination.

In addition, throughout this specification, it will be further understood that when an element is referred to as being "connected to" another element, it can be directly connected to the other element or intervening elements may be present.

In battery charging, fast charging using high-rate charge current may significantly reduce the charging time compared to slow charging using low-rate charge current, but causes grave damage to batteries, resulting in shorter battery life.

As the charge current is higher, 'lithium plating' may occur more easily when lithium ions in batteries deposit as metallic lithium on negative electrode surface, which reduces the amount of lithium ions that can participate in charging and discharging reactions as much as the amount of lithium plating, and aggravates imbalance between positive electrode potential and negative electrode potential. In addition, there is a high risk that separators are torn due to excessive lithium metal growth, causing internal short circuit failures, and the internal short circuit failures increase the risk of explosion and fire in batteries.

The present disclosure proposes an approach to establish a quick charging protocol for avoiding lithium plating over the entire life of batteries after the manufacture of the batteries without manufacturing a test cell (for example, a three-electrode monocell) by acquiring characteristic information (for example, state of charge (SOC)-internal resistance relationship) of the batteries related to potential lithium plating and calculating the depth of charge during fast charging using the same.

For example, in the case of medium- and large-sized pouch cells used in electric vehicles, lithium metal deposits are formed on the negative electrode surface with use, and the resistance of the lithium metal deposits is combined in parallel with the surface resistance of the negative electrode, and as a result, the total resistance on the negative electrode surface of the pouch cell may decrease when lithium metal deposition occurs. In this case, battery impedance changes, and reference frequency may be determined to suit the charging condition at the start of intermittent charging process by Electrochemical Impedance Spectroscopy (EIS) using the changed impedance graph. An appropriate resting period in the middle of the intermittent charging process may be calculated based on the reference frequency of the intermittent charging process. During the appropriate resting period, for example, voltage changes or resistance changes as a function of internal resistance of the battery may be observed, and the depth of charge of the battery may be calculated using the same. The theoretical background of lithium plating and battery surface resistance and the method for calculating the appropriate resting period will be described in more detail below.

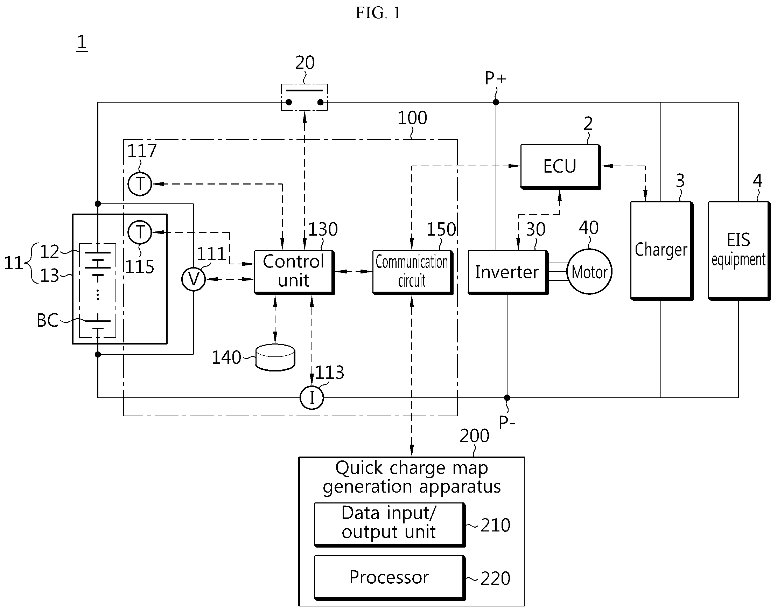

FIG. 1 is a diagram exemplarily showing the architecture of a charging system according to an embodiment of the present disclosure. The charging system as described below may, for example, acquire necessary characteristic information of a commercially available secondary battery 11 by connecting the charging system to the secondary battery with or without a test jig.

Referring to FIG. 1, the charging system 1 may be the term of concept that encompasses not only a test system used to identify/verify the electrical properties of the battery, but also an electrical system using the battery as a power source, such as, for example, an electric vehicle.

The charging system 1 includes a charger 3, a charging test apparatus 100 and a quick charge map generation apparatus 200. The charging system 1 may further include at least one of a system controller (an Electronic Control Unit (ECU)) 2, a switch 20, an inverter 30 or an electric motor 40.

Charge/discharge terminals P+, P- of the battery 11 may be electrically connected to the inverter 30 and/or the charger 3 through a charging cable.

The system controller 2 is configured to transmit a key-ON signal to the charging test apparatus 100 in response to a user's switching of a start button (not shown) of the charging system 1 to an ON position. The system controller 2 is configured to transmit a key-OFF signal to the charging test apparatus 100 in response to the user's switching of the start button to an OFF position. The charger 3 may supply the charge power to the battery 11 through the charge/discharge terminals P+, P- according to at least one charging protocol (for example, constant current charging, constant voltage charging and/or constant power charging) by communication with the system controller 2.

The charging test apparatus 100 may also perform the function(s) of a battery management system (BMS).

The battery 11 may refer to one battery cell BC or a group 12 of two or more battery cells BC. The battery cell BC is not limited to a particular type and may include any type of rechargeable battery cell, such as, for example, a lithium-ion cell. When the battery 11 includes a plurality of battery cells BC, the plurality of battery cells may be connected either in series or in parallel, or both.

The battery further includes a case 13. The case 13 defines the overall appearance of the battery 11 and provides an internal space in which the cell group 12 may be positioned. The case 13 is securely fixed to a battery room of the charging system 1 through bolts.

The switch 20 is electrically connected in series to the battery 11 through a power path connecting the battery 11 to the inverter 30. FIG. 1 shows the switch 20 connected between the positive terminal of the battery 11 and the charge/discharge terminal P+. The switch 20 is controlled to turn on/off in response to a switching signal from the charging test apparatus 100. According to an embodiment of the present disclosure, the switch 20 may include a mechanical contactor that is turned on/off by the magnetic force of a coil or a semiconductor switch such as a Metal Oxide Semiconductor Field Effect transistor (MOSFET).

The inverter 30 is provided to convert direct current (DC) from the battery 11 to alternating current (AC) in response to a command from the charging test apparatus 100 or the system controller 2.

The electric motor 40 is an example of an electrical load that operates using AC power from the inverter 30. The electric motor 40 may include, for example, a three-phase AC motor.

The charging test apparatus 100 is provided to perform a charging test according to a plurality of charging conditions as described below. The charging test apparatus 100 includes a voltage sensor 111, a current sensor 113, a temperature sensor 115, a control unit 130 and a memory 140. The charging test apparatus 100 may further include a temperature sensor 117. The charging test apparatus 100 may further include a communication circuit 150.

The voltage sensor 111 is connected in parallel to the battery 11 and is configured to measure a battery voltage across the battery 11, and generate a voltage signal indicating the measured battery voltage.

The current sensor 113 is connected in series to the battery 11 through a current path between the battery 11 and the inverter 30. The current sensor 113 is configured to measure a battery current flowing through the battery 11, and generate a current signal indicating the measured battery current. The current sensor 113 may include one of known current measuring devices such as a shunt resistor or a Hall effect element or a combination thereof.

The temperature sensor 115 is configured to measure a temperature of the battery 11 and generate a temperature signal indicating the measured battery temperature. The temperature sensor 115 may be attached to the surface of the battery 11 to measure the temperature close to the actual temperature of the battery 11. For reference, a 'temperature measurement value' as described herein may refer to a battery temperature measurement value.

The temperature sensor 117 is configured to measure outdoor air temperature (ambient temperature) at a predetermined location away from the battery 11 where heat exchange between the battery 11 and outdoor air takes place, and generate a temperature signal indicating the measured ambient temperature.

Any one of the voltage sensor 111, the current sensor 113, the temperature sensor 115 and the temperature sensor 117 or a combination thereof may be referred to as 'sensing unit'.

Each of the temperature sensors 115, 117 may include, for example, one of temperature measuring devices such as a thermocouple, a thermistor or a bimetal or a combination thereof.

The communication circuit 150 is configured to support wired communication or wireless communication between the control unit 130 and the system controller 2. The wired communication may include, for example, controller area network (CAN) communication, and the wireless communication may include, for example, Zigbee or Bluetooth communication. The communication protocol is not limited to a particular type and may include any type of communication protocol that supports wired or wireless communication between the control unit 130 and the system controller 2. The communication circuit 150 may include an output device (for example, a display, a speaker) to provide information received from the control unit 130 and/or the system controller 2 in a recognizable form for the user.

The control unit 130 is operably coupled to the switch 20, the voltage sensor 111, the current sensor 113, the temperature sensor 115, the temperature sensor 117 and the communication circuit 150. Here, "operably coupled" refers to indirect/direct connection to enable signal transmission and reception in one or two directions.

The control unit 130 may collect the voltage signal from the voltage sensor 111, the current signal from the current sensor 113, the temperature signal (referred to as 'battery temperature signal') from the temperature sensor 115 and/or the temperature signal (referred to as 'ambient temperature signal') from the temperature sensor 117. The control unit 130 may convert and record each analog signal collected from the sensors 111, 113, 115, 117 into a digital value using an Analog-to-Digital Converter (ADC) equipped therein.

The control unit 130 may be also referred to as a 'control circuit' or a 'battery controller', and may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing other functions.

The memory 140 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory 140 may store data and programs required for the operation by the control unit 130. The memory 140 may store data indicating the results of the operation by the control unit 130. Although FIG. 1 shows the memory 140 physically independent from the control unit 130, the memory 140 may be present within the control unit 130.

The control unit 130 may turn on the switch 20 in response to the key-ON signal. The control unit 130 may turn off the switch 20 in response to the key-OFF signal. The key-OFF signal is a signal that triggers switching from a cycling state in which the battery 11 is being charged and discharged to a resting state in which charging and discharging of the battery 11 is stopped. Alternatively, the system controller 2 may take responsibility for the ON/OFF control of the switch 20 in place of the control unit 130.

When the inverter 30 or the charger 3 operates while the switch 20 is turned on, the battery 11 is in the cycling state. In contrast, when the switch 20 is turned off or the operation of the inverter 30 and the charger 3 is stopped, the battery 11 is in the resting state.

The control unit 130 may determine a voltage measurement value, a current measurement value, a battery temperature measurement value and an ambient temperature measurement value based on the voltage signal, the current signal, the battery temperature signal and the ambient temperature signal while the battery 11 is in the cycling state and/or the resting state, and determine (estimate) the SOC of the battery 11 based on the voltage measurement value, the current measurement value and/or the battery temperature measurement value.

During operation of the charger 3 in the constant current charge mode, the current rate ('C-rate') of the charge current supplied to the battery 11 is a known constant value, so in the SOC estimation of the battery 11, instead of the current measurement value acquired using the current sensor 113, the current value of the constant current output from the charger 3 may be used.

The SOC indicates a ratio of the remaining capacity of the battery 11 to its full charge capacity (maximum capacity), and is generally processed within a range between 0 and 1 or between 0% and 100%. The SOC may be, for example, determined using ampere counting, Open Circuit Voltage (OCV)-SOC curve and/or Kalman filter.

The charging system 1 may further include an EIS equipment 4. The EIS equipment 4 is provided to apply an AC signal to the battery 11 and measure response characteristics of the battery 11 to the applied AC signal. Although FIG. 1 shows the EIS equipment 4 connected in parallel to the battery 11, the EIS equipment 4 is not limited thereto. For example, the EIS equipment 4 may be selectively connected to the battery 11 by a switching circuit.

Below is a description of the process of connecting the above-described charging system to the commercially available secondary battery, for example, a medium- and large-sized pouch cell used in an electric vehicle through the test jig, performing the 'intermittent charging process' including the above-described appropriate resting period and acquiring the characteristic information of the battery 11 in the rest mode of the intermittent charging process.

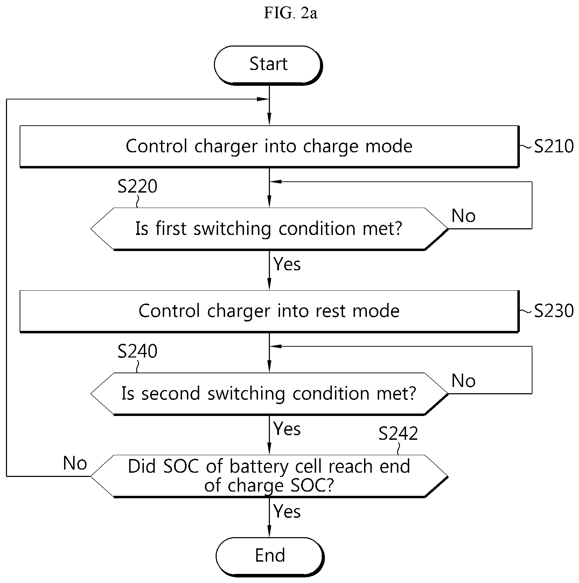

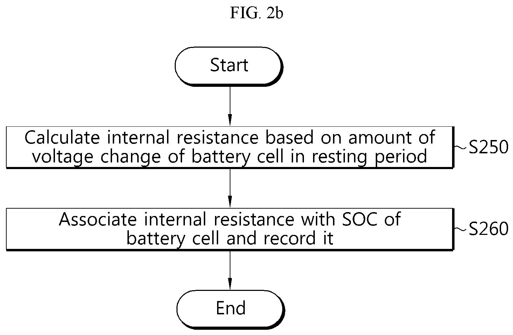

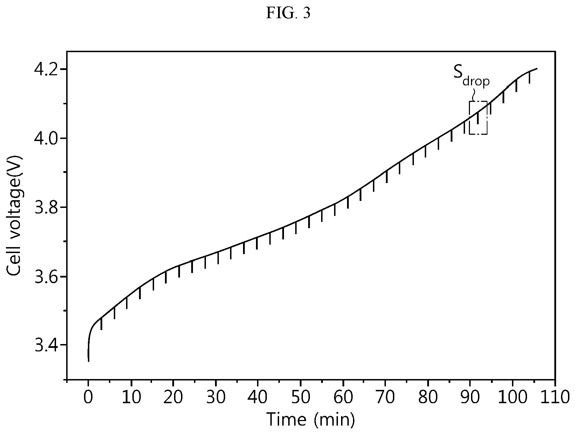

FIGS. 2a and 2b are flowcharts exemplarily showing a charging test method according to a first embodiment of the present disclosure, and FIGS. 3 to 7 are diagrams referenced in describing the method of FIGS. 2a and 2b.

The method of FIG. 2a may be performed by the charging test apparatus 100 shown in FIG. 1 on the condition that the battery temperature of the battery 11 is consistent with the ambient temperature for each charging condition. A set of steps S210 to S250 included in FIG. 2a may be collectively referred to as a control step of the 'intermittent charging process'. The method of FIG. 2a may be repeatedly performed until the SOC of the battery 11 reaches a predetermined upper SOC limit (referred to as 'end of charge SOC') from a predetermined lower SOC limit (referred to as 'start of charge SOC').

Each of the lower SOC limit and the upper SOC limit may be set according to the magnitude of charge current (i.e., C-rate) used in the charge mode of the method of FIG. 2a and the ambient temperature at the start time of the method of FIG. 2a.

For example, the lower SOC limit and the upper SOC limit may be set to 88% and 97% when the C-rate and the ambient temperature are 0.5C and 25°C, to 68% and 77% when the C-rate and the ambient temperature are 2C and 25°C, and to 63% and 72% when the C-rate and the ambient temperature are 2C and 10°C. Relationship data of the lower SOC limit and the upper SOC limit for each charging condition defined by the C-rate and the ambient temperature may be pre-recorded in the memory 140 in the form of a lookup table and/or a function.

Referring to FIGS. 1, 2a, and 2b, in the step S210, the control unit 130 controls the charger 3 into the charge mode for charge current supply to the battery 11. For example, the control unit 130 transmits a charging request signal to the charger 3 through the communication circuit 150, and the charger 3 operates in the charge mode in response to the charging request signal to supply the charge current having a requested C-rate from the charging request signal to the battery 11. Here, the charge mode may be, for example, the constant current charge mode of charging the battery 11 at the predetermined C-rate of charge current.

In the step S220, the control unit 130 determines whether a first switching condition for switching from the charge mode to the rest mode is met. The first switching condition may be a time-based condition or an SOC-based condition. As an example, it may be determined that the first switching condition is met in response to the duration of the charge mode (for example, the time that has passed from the start of the charge mode) reaching a first reference time. As another example, it may be determined that the first switching condition is met in response to an SOC increase amount of the battery 11 by the charge mode (i.e., a difference between the SOC at the start time of the current charge mode and the current SOC) reaching a reference increase amount (for example, 0.5%). When a value of the step S220 is "No", the step S220 may be repeatedly performed again. When the value of the step S220 is "Yes", i.e., it is determined that the first switching condition is met in the S220, the step S230 is performed.

In the step S230, the control unit 130 controls the charger 3 into the rest mode. Accordingly, the intermittent charging process is switched from the charge mode to the rest mode. For example, when the control unit 130 transmits a charging stop signal to the charger 3 through the communication circuit 150, the charger 3 enters the rest mode in response to the charging stop signal. In the rest mode, the charge current supply from the charger 3 to the battery 11 is interrupted. The control unit 130 may record the SOC of the battery 11 at the time of switching from the charge mode to the rest mode in the memory 140.

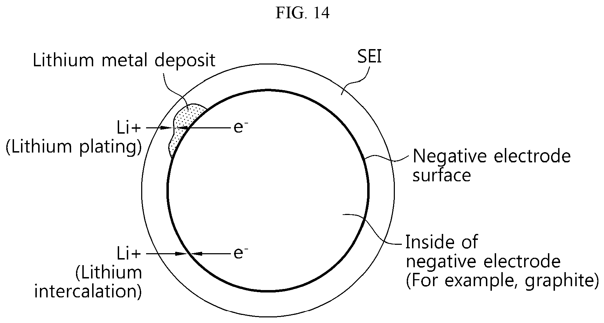

In the step S240, the control unit 130 determines whether a second switching condition for switching from the rest mode to the charge mode is met. The second switching condition may be a time-based condition. For example, it may be determined that the second switching condition is met in response to the duration of the rest mode (i.e., the time that has passed from the start of the rest mode) reaching a second reference time. The second reference time may be a preset fixed time or a variable period that is adjusted by the control unit 130 based on electrochemical property data of the battery 11. The adjustment of the second reference time will be described with reference to FIG. 14. When a value of the step S240 is "No", i.e., the duration of the rest mode does not reach the second reference time, the step S240 may be repeatedly performed again. When the value of the step S240 is "Yes", i.e., the duration of the rest mode reaches the second reference time, the step S250 may be performed.

In the step S250, the control unit 130 determines whether the SOC of the battery 11 reached the end of charge SOC. When a value of the step S250 is "No", the method may return to the step S210. For example, in the intermittent charging process, the charge mode and the rest mode may be repeated until the SOC of the battery 11 reaches the end of charge SOC after switching from the rest mode to the charge mode. In contrast, when the value of the step S250 is "Yes", for example, the SOC of the battery 11 reaches the end of charge SOC, the method according to FIG. 2a may end.

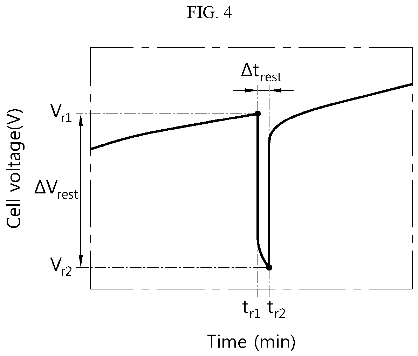

A voltage (V) vs time (min) graph as shown in FIG. 3 may be acquired by repeating the charge mode and the rest mode through the steps according to FIG. 2a as described above. In FIG. 3, the comb-like pattern indicates the resting period of the intermittent charging process as shown in FIG. 4.

The method of FIG. 2b may be performed on the condition that the measurement value in the step S240 of FIG. 2a is "Yes". For example, the method of FIG. 2b may include performing the step S260 as described below before moving to the step S250 when the second switching condition is met in the step S240.

In the step S260, the control unit 130 calculates an internal resistance of the battery 11 based on an amount of voltage change of the battery 11 in the resting period. In the step S270, the control unit 130 associates the internal resistance calculated in the step S260 with the SOC of the battery 11 and records it.

While the method according to FIGS. 2a and 2b is performed, the battery temperature of the battery 11 may be measured periodically or aperiodically, and history data of the measured battery temperature may be recorded in the memory 140 by the control unit 130.

The method according to FIGS. 2a and 2b may be individually performed on the plurality of charging conditions.

FIG. 3 is a graph exemplarily showing battery voltage change history during the charging test period in which the intermittent charging process is performed. As can be seen through FIG. 3, the voltage of the battery 11 generally shows an upward trend throughout the charging test period, and as indicated by the comb-like pattern in the graph, voltage rise sections during operation of the charger 3 in the charge mode and voltage drop sections during operation of the charger 3 in the rest mode are repeated in an alternating manner.

FIG. 4 is a graph showing an enlarged view of the voltage drop section $S_{drop}$ in the rest mode indicated by the dotted box area in FIG. 3. In FIG. 4, $t_{r1}$ indicates the time when the charger 3 is requested to switch from the charge mode to the rest mode (or the time when a switching event from the charge mode to the rest mode occurs), $t_{r2}$ indicates the time when the charger 3 is requested to switch from the rest mode to the charge mode (or the time when a switching event from the rest mode to the charge mode occurs), $\Delta t_{rest}$ indicates the duration of the rest mode (the time length of the resting period), $V_{r1}$ indicates the battery voltage at $t_{r1}$, $V_{r2}$ indicates the battery voltage at $t_{r2}$, and $\Delta V_{rest}$ indicates the amount of voltage change in the rest mode. That is, $V_{r1}$ indicates the battery voltage measured immediately before switching from the charge mode to the rest mode, and $V_{r2}$ indicates the battery voltage measured immediately before switching from the rest mode to the charge mode. $\Delta t_{rest} = t_{r2} - t_{r1}$ and $\Delta V_{rest} = V_{r1} - V_{r2}$.

The control unit 130 may calculate (estimate) the internal resistance every resting period by using Equation 1 below.

$$<\text{Equation 1}>$$

$$R_{CT} = \frac{\Delta V_{rest}}{I_{CC}}$$

In the above Equation 1, $I_{CC}$ denotes the charge current (for example, the predetermined C-rate of constant current), and $R_{CT}$ denotes the internal resistance.

In the step S270, the control unit 130 associates the internal resistance acquired in the step S260 with the SOC of the battery 11 and records it in the memory 140. The SOC associated with the internal resistance may be SOC of the battery 11 at the time of switching from the charge mode to the rest mode (i.e., the time when the step S230 is performed).

As shown in FIG. 3, the rest mode may work multiple times (i.e., the plurality of resting periods may sequentially proceed during the charging test period) during charging in an SOC range of interest (i.e., from the lower SOC limit to the upper SOC limit), and the estimated internal resistance in the resting period each time the rest mode works may be sequentially recorded in the memory 140 in a chronological order.

Accordingly, when the SOC of the battery 11 reaches the upper SOC limit, resistance time-series datasets (referred to as 'internal resistance map') indicating internal resistance change history over time may be recorded in the memory 140. Each data point of the resistance time-series dataset may indicate the relationship pair of internal resistance and SOC determined in the specific resting period during the charging test period.

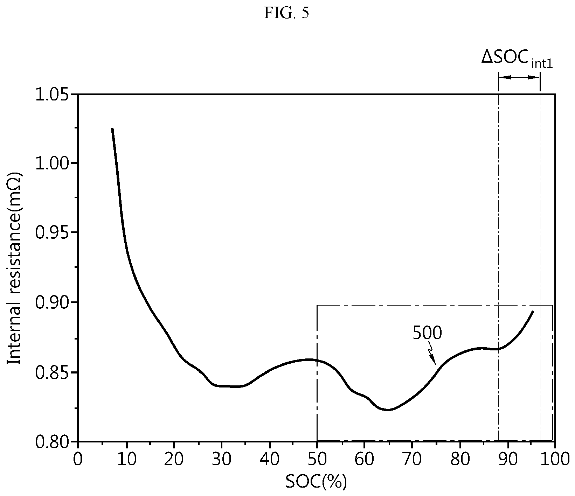

FIGS. 5 to 7 are graphs 500, 600, 700 exemplarily showing three typical patterns of resistance time-series datasets acquired by repeatedly performing the intermittent charging process using three different charging conditions, respectively. For example, charge transfer resistance graphs acquired from evaluation of the present disclosure may be classified as three cases of FIGS. 5, 6, and 7 as described below, and each diagram shows an example of evaluation condition and environment. However, measurements may not be done in the corresponding conditions described below, and for evaluation, intermittent charging may be performed in any other conditions. In the following description, the depth of charge may be more accurately identified in a direction in which the depth of charge decreases (the charge transfer resistance of the battery decreases) in the order of FIGS. 5, 6 and 7.

FIG. 5 shows the resistance time-series dataset 500 acquired by performing the intermittent charging process in the first charging condition in which the C-rate of the charge current is 0.5 C and the battery temperature (for example, temperature measured when starting the intermittent charging process for the first time) is 25°C. $\Delta SOC_{int1}$ indicates the SOC range of interest (for example, 88% to 97%) in the resistance pattern associated with the first charging condition.

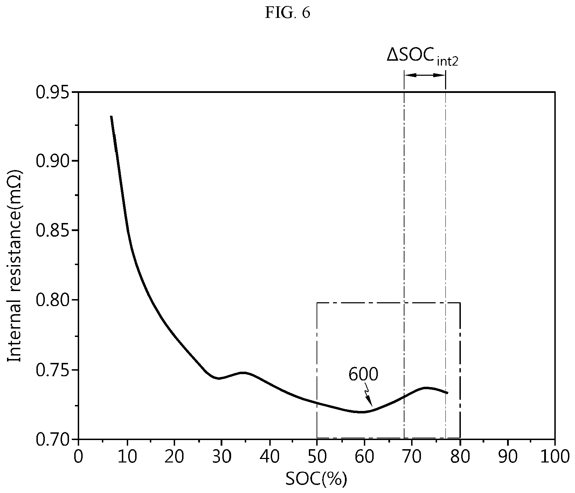

FIG. 6 shows the resistance time-series dataset 600 acquired by performing the intermittent charging process in the second charging condition in which the C-rate of the charge current is 2C and the battery temperature (for example, temperature measured when starting the intermittent charging process for the first time) is 25°C. $\Delta SOC_{int2}$ indicates the SOC range of interest (for example, 68% to 77%) in the resistance pattern associated with the second charging condition.

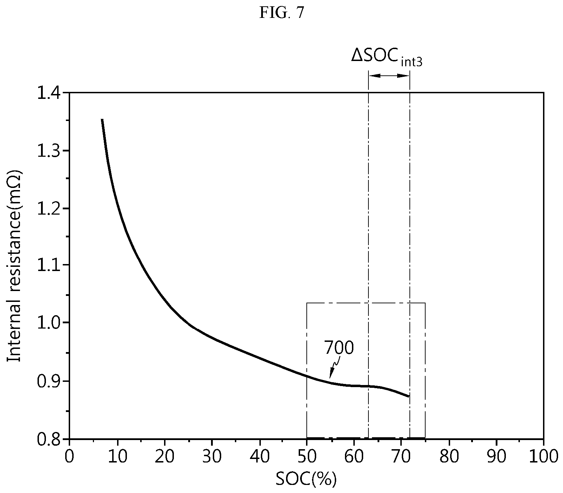

FIG. 7 shows the resistance time-series dataset 700 acquired by performing the intermittent charging process in the third charging condition in which the C-rate of the charge current is 2C and the battery temperature (for example, temperature measured when starting the intermittent charging process for the first time) is 10°C. $\Delta SOC_{int3}$ indicates the SOC range of interest (for example, 63% to 72%) in the resistance pattern associated with the third charging condition.

The upper limit of each SOC range of interest may be referred to as charge limit SOC.

When comparing FIG. 5 with FIG. 6, the first charging condition and the second charging condition have the same battery temperature, but the first charging condition is lower in C-rate than the second charging condition. Accordingly, because the first charging condition is a less harsh condition for the battery 11 than the second charging condition, the upper SOC limit (97%) associated with the first charging condition is set higher than the upper SOC limit (77%) associated with the second charging condition as shown.

When comparing FIG. 6 with FIG. 7, the second charging condition and the third charging condition have the same C-rate, but the third charging condition is lower in temperature than the second charging condition, and electrochemical reactions of the battery 11 may be slower in the second charging condition than the third charging condition. Accordingly, the upper SOC limit (72%) associated with the third charging condition is lower than the upper SOC limit (77%) associated with the second charging condition as shown.

Although FIGS. 5 to 7 show the internal resistance change history (reflecting the charge transfer resistance) in a wider range than the SOC range of interest corresponding to each charging condition, this is provided to help understanding, and the internal resistance change history within the SOC range of interest corresponding to each charging condition may only be acquired.

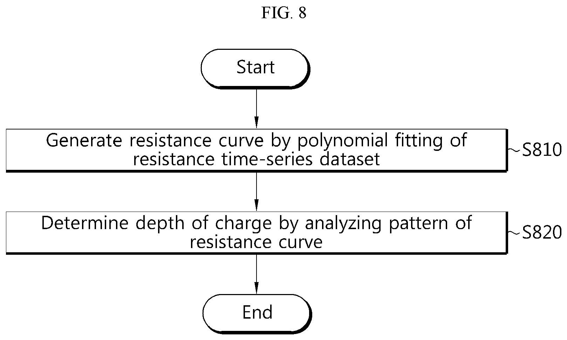

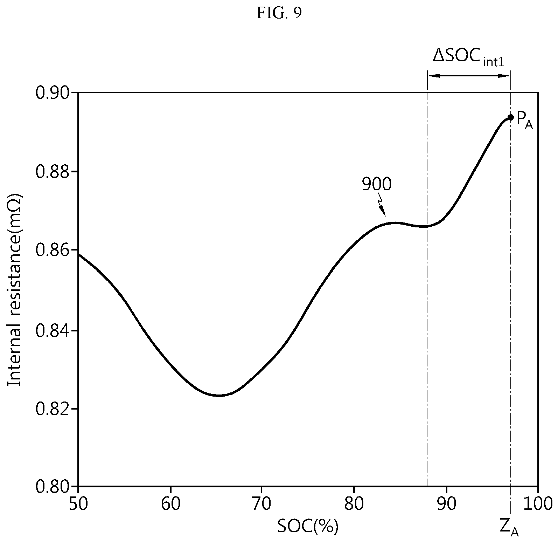

FIG. 8 is a flowchart exemplarily showing the charging test method according to a second embodiment of the present disclosure, and FIGS. 9 to 13 are graphs exemplarily showing resistance profiles referenced in describing the method of FIG. 8. The method of FIG. 8 may be performed after acquiring the resistance time-series dataset during the charging test period by the charging test method according to the first embodiment described above with reference to FIGS. 2a and 2b.

Referring to FIG. 8, in step S810, the control unit 130 generates the resistance profile (also referred to as 'internal resistance profile') representing the relationship between the SOC and the internal resistance of the battery 11 by curve fitting of the resistance time-series dataset. The curve fitting may refer to a procedure or logic for approximation of an input dataset by a polynomial having a predetermined degree. That is, the resistance profile may be a sort of function that takes SOC as input and gives internal resistance as output.

FIGS. 9 to 11 show three resistance profiles 900, 1000, 1100 acquired by curve fitting of the three resistance time-series datasets 500, 600, 700 described above with reference to FIGS. 5 to 7 by a 9th degree polynomial, respectively. To help understanding, FIGS. 9 to 11 show the three resistance profiles 900, 1000, 1100 in a range from SOC 50% that is lower than the lower SOC limit of the three SOC ranges of interest $\Delta SOC_{int1}$, $\Delta SOC_{int2}$, $\Delta SOC_{int3}$ to the upper SOC limit, respectively.

In step S820, the control unit 130 determines the depth of charge of the battery 11 based on the pattern of the resistance profile. The depth of charge indicates the maximum SOC (which may be within the SOC range of interest) at which the battery 11 can be charged without lithium plating. A data point as a pair of the depth of charge determined in the step S820 and its corresponding battery temperature may be recorded in the memory 140 as the charging test result.

First, the operation of identifying the depth of charge from the resistance profile 900 shown in FIG. 9 acquired by curve fitting of the time-series dataset of FIG. 5 will be described. Referring to FIG. 9, in the SOC range of interest $\Delta SOC_{int1}$, the internal resistance keeps increasing without any decrease. As shown in FIG. 9, when the continuous increasing pattern of the internal resistance with the increasing SOC is identified, the control unit 130 may determine the SOC $Z_A$ at an endpoint $P_A$ on the resistance profile 900 as the depth of charge $Z_A$. That is, in the case of the pattern shown in FIG. 9, the depth of charge $Z_A$ may be determined to be equal to the upper SOC limit of the SOC range of interest $\Delta SOC_{int1}$. The increasing pattern of a profile (or a curve) may indicate that the first-order derivative of the profile is a positive number.

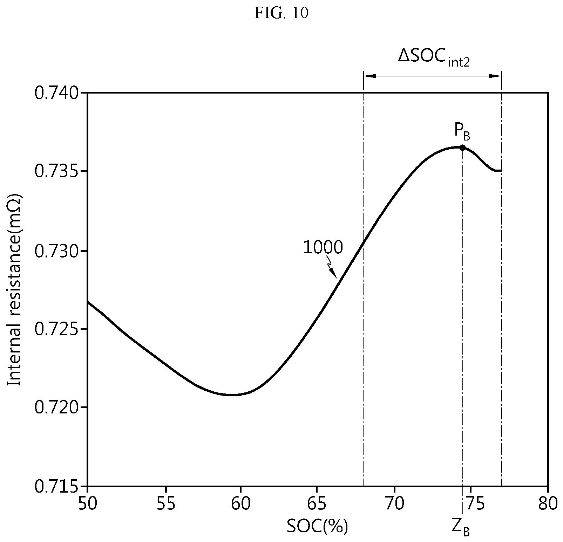

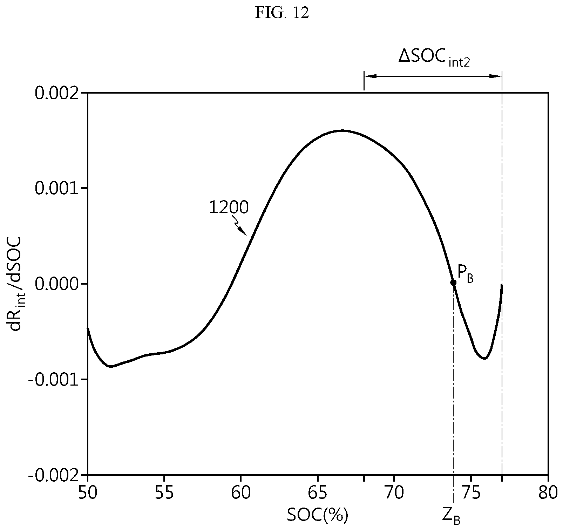

Subsequently, the operation of identifying the depth of charge from the resistance profile 1000 shown in FIG. 10 acquired by curve fitting of the time-series dataset of FIG. 6 will be described. Referring to FIG. 10, the internal resistance gradually increases at the former portion of the SOC range of interest $\Delta SOC_{int2}$, and from a specific SOC, gradually decreases, as opposed to the resistance profile 900 shown in FIG. 9. As shown in FIG. 10, when the increasing section and the decreasing section of the internal resistance adjoin, the control unit 130 may acquire a differential resistance profile by first-order differentiation of the resistance profile 1000 with respect to SOC. For example, the differential resistance profile 1200 of FIG. 12 is shown as a result of first-order differentiation of the resistance profile 1000 of FIG. 10. The control unit 130 may determine the depth of charge $Z_B$ to be equal to SOC at a boundary point where a differential resistance value $dR_{CT}/dSOC$ in the differential resistance profile 1200 changes from positive to negative as the SOC increases, i.e., a feature point $P_B$ where the differential resistance value $dR_{CT}/dSOC$ is 0. The depth of charge $Z_B$ determined from the differential resistance profile 1200 of FIG. 12 may be determined to be equal to SOC at the boundary point between the increasing pattern and the decreasing pattern of the internal resistance in the resistance profile 1000 of FIG. 10. For reference, the decreasing pattern of a profile (or a curve) may indicate that the first-order derivative of the profile is a negative number.

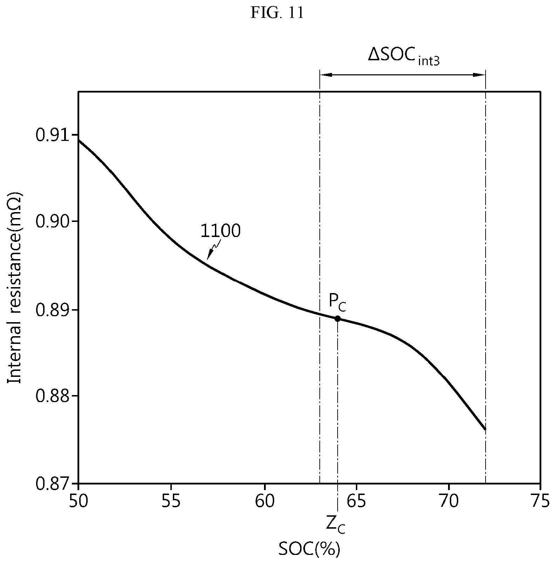

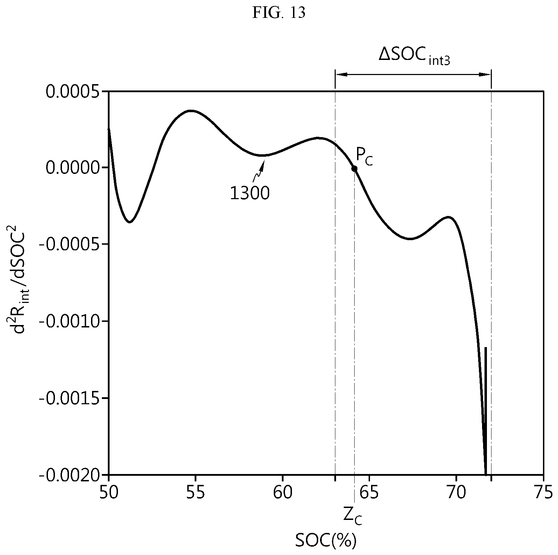

Subsequently, the operation of identifying the depth of charge from the resistance profile 1100 shown in FIG. 11 acquired by curve fitting of the time-series dataset of FIG. 7 will be described. Referring to FIG. 11, as opposed to the resistance profile 900 of FIG. 9 and the resistance profile 1000 of FIG. 10, the internal resistance in the SOC range of interest $\Delta SOC_{int3}$ keeps decreasing without any increase. As shown in FIG. 11, when the internal resistance in the SOC range of interest only shows the decreasing pattern, the control unit 130 may acquire a differential resistance profile 1300 as shown in FIG. 13 by second order differentiation of the resistance profile 1100 with respect to SOC. For reference, while the differential resistance profile 1200 is the result of first order differentiation of the resistance profile 1000, the differential resistance profile 1300 is the result of second order differentiation of the resistance profile 1100.

The control unit 130 may determine the depth of charge $Z_C$ to be equal to SOC at a point where a second-order differential resistance value $d^2R_{CT}/dSOC^2$ in the differential resistance profile 1300 changes from positive to negative as the SOC increases, i.e., a feature point $P_C$ where the second-order differential resistance value $d^2R_{CT}/dSOC^2$ is 0. The feature point $P_C$ may be a point where the absolute value of resistance change in the resistance profile 1100 is the largest.

The depth of charge $Z_A$, $Z_B$, $Z_C$ shown in FIGS. 9 to 13 indicate SOC at which the battery 11 can be charged without lithium plating when constant current charging at its associated C-rate (for example, 2C), respectively. For example, when charging still continues in the same charging condition after the SOC of the battery 11 reaches the depth of charge, lithium plating may occur on the negative electrode surface of the battery 11.

In step S830, the control unit 130 may record the charging test result indicating the depth of charge determined in the step S820 and the battery temperature (cell temperature) at a timing corresponding to the depth of charge in the memory 140. The charging test result may be a two-dimensional (2D) data point defined by the depth of charge and the battery temperature.

The control unit 130 may record the depth of charge and the battery temperature determined in the specific charging condition (for example, C-rate of 0.5C and ambient temperature of 25°C) in the memory 140 as the charging test result in the specific charging condition.

The methods of FIGS. 2a and 2b and FIG. 8 may be performed each time the charging event according to each of the plurality of charging conditions takes place, and the plurality of charging test results respectively associated with the plurality of charging conditions may be acquired accordingly. The quick charge map generation apparatus 200 as described below may generate a quick charge map for the battery cell BC or another battery cell manufactured with electrochemical properties of the same specification based on the plurality of charging test results.

After the generation of the quick charge map is completed, the control unit 130 may identify the depth of charge (for example, $Z_A$) according to the battery temperature (cell temperature) and the C-rate of the battery cell BC being charged from the quick charge map, and stop the charging of the battery 11 when the SOC of the battery is equal to or more than the identified depth of charge (for example, $Z_A$). For example, when the SOC of the battery reaches the identified depth of charge, the control unit 130 may control the switch 20 into OFF state or transmit a charging stop request to the charger 3.

The methods of FIGS. 2a and 2b and FIG. 8 may be performed on the condition that a preset event requiring diagnosis occurred due to a decrease in State Of Health (SOH) of the battery by a predetermined amount or more from the previous SOH.

FIGS. 14 to 16 are diagrams referenced in describing a relationship between lithium plating and impedance during charging of the battery.

First, FIG. 14 is a diagram showing lithium metal deposition on the negative electrode of the battery 11. Referring to FIG. 14, during charging according to a certain charging condition, lithium ions may deposit as metallic lithium on the negative electrode surface of the battery 11. When lithium metal deposition occurs, lithium intercalation and lithium plating take place on the negative electrode surface of the battery 11 at the same time, and accordingly, the charge current's movement path may be extended compared to the charge current's movement path in the absence of lithium metal deposition.

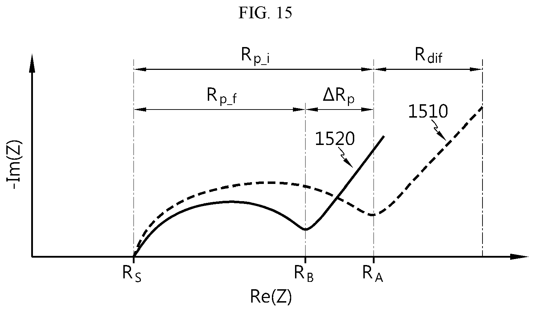

FIG. 15 is a graph referenced in describing changes in impedance of the battery 11 depending on the presence or absence of lithium plating in the battery 11 by way of illustration. Each of two complex impedance curves 1510, 1520 shown in FIG. 15 may be acquired by repeating a process of measuring the impedance of a battery with lithium plating and a battery without lithium plating when applying an AC signal to each battery using the EIS equipment 4, under the same environmental conditions, respectively. For example, FIG. 15 may be a Nyquist plot representing changes in impedance of the battery with changes in frequency of the AC signal. Because the process of acquiring the plurality of impedance curves of the battery 11 is performed one time before the start of the intermittent charging process on the battery 11, and the AC signal by the EIS equipment 4 is applied to the battery for a short time, it causes no or little damage to the battery.

According to an embodiment, the complex impedance curve 1510 may be acquired from the battery before lithium plating occurs, and the complex impedance curve 1520 may be acquired from the battery after lithium plating occurs.

$R_S$ indicates the electrolyte resistance of the battery, and is hardly affected by the presence or absence of lithium plating. $R_{p\_i}$ and $R_{p\_f}$ indicate the interfacial resistance of the battery without and with lithium plating, respectively. $R_A$ and $R_B$ indicate the internal resistance of the battery without and with lithium plating, respectively, where $R_A = R_S + R_{p\_i}$ and $R_B = R_S + R_{p\_f}$.

The interfacial resistance is the total resistance by solid electrolyte interphase (SEI), charge transfer and double layer, and is greatly affected by charge accumulation on the positive electrode surface and the negative electrode surface of the battery.

As described above with reference to FIG. 14, because the resistance of lithium metal deposition on the negative electrode surface is combined in parallel with the resistance on the negative electrode surface, as a result, the total resistance on the negative electrode surface of the battery may be reduced when lithium metal deposition occurs. Accordingly, as can be seen through FIG. 15, $R_{p\_f}$ is smaller than $R_{p\_i}$, and a resistance difference $\Delta R_p$ between them has a positive correlation with the amount of lithium metal deposits.

Meanwhile, the control unit 130 may determine the reference frequency from the complex impedance curve 1510. For example, the complex impedance curve 1510 may be divided into a convex section and a sloping section. Here, the convex section may be associated with the interfacial resistance $R_{p\_i}$. The sloping section is a straight line section extended from the right side of the convex section, and indicates the diffusion resistance $R_{diff}$ of the battery. The frequency of the applied AC signal at the boundary point (see $R_A$) between the convex section and the sloping section may be determined as the reference frequency.

The inventors were aware of the characteristic that the SOC of the battery 11 gradually increases during the intermittent charging process, and as the SOC increases, the frequency at the boundary point between the convex section and the sloping section gradually increases. When the reference frequency is determined to suit the charging condition at the start of the intermittent charging process, the resting period in the middle of the intermittent charging process may last for the appropriate time required to observe voltage changes by the internal resistance of the battery 11. Accordingly, it may be possible to prevent the accuracy of internal resistance from decreasing due to too long or short time length of the resting period.

The control unit 130 may determine the second reference time indicating the duration of the resting mode based on the reference frequency. The reference frequency and the second reference time may have a predetermined negative correspondence relationship. The relationship data represented by Equation 2 below may be used to determine the second reference time.

<Equation 2>

$$\Delta t_{R2} = \frac{1}{f_{i-d}} \times w$$

In the above Equation 2, $f_{i-d}$ denotes the reference frequency, w denotes a predetermined margin constant (which may be equal to or larger than 1), and $\Delta t_{R2}$ denotes the second reference time. Accordingly, the second reference time may be set to be equal to or larger than a value obtained by multiplying the reciprocal of the reference frequency $f_{i-d}$ by the margin constant w. The second reference time may be the duration per resting period required to observe voltage changes by the internal resistance of the battery 11.

The memory 140 may pre-record the reference frequency for each charging condition and lower SOC limit. The control unit 130 may determine the second reference time by acquiring the reference frequency associated with the charging condition of the intermittent charging process that will be performed on the battery 11 and the lower SOC limit of the SOC range of interest from the memory 140.

The memory 140 may store relationship data between the SOC, the battery temperature and the reference frequency. The relationship data between the SOC, the battery temperature and the reference frequency may be replaced with relationship data between the SOC, the battery temperature and the second reference time.

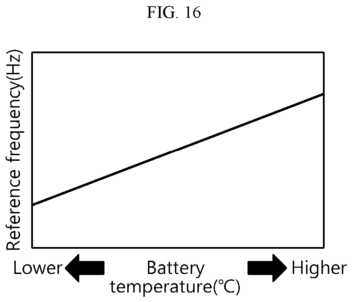

FIG. 16 is a graph referenced in describing the relationship between the battery temperature and the reference frequency when the SOC of the battery 11 is set to a specific value (for example, lower SOC limit 10%).

Referring to FIG. 16, when other factors (for example, C-rate, upper SOC limit) of the charging condition are the same, as the battery temperature of the charging condition is higher, its associated reference frequency may be higher. That is, the battery temperature and the reference frequency may have a positive correlation.

Referring to the above Equation 2, because the reference frequency and the second reference time are inversely proportional, as the battery temperature of the battery 11 is higher at the time when the control of the intermittent charging process starts, the shorter duration of the resting mode (i.e., the second reference time) may be set.

Although FIG. 1 shows the charging test apparatus 100 as the sub-component of the charging system, the charging test apparatus 100 is not limited thereto. For example, the charging test apparatus 100 may be used as the sub-component of a charging performance test apparatus for determining the depth of charge according to the charging conditions of the battery 11. In this case, the charging performance test apparatus may include the charging test apparatus 100 and the charger 3.

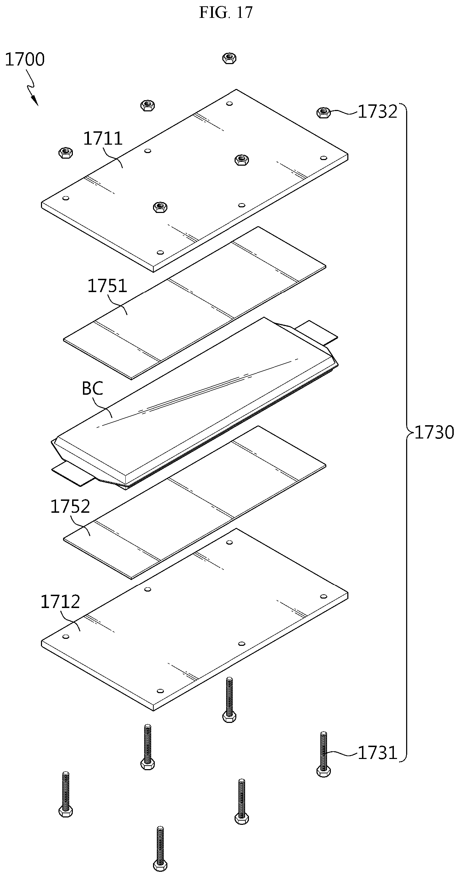

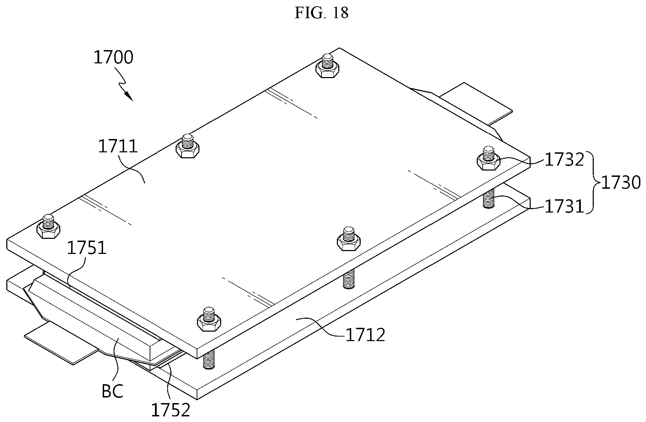

FIGS. 17 and 18 are diagrams exemplarily showing the structure of a test jig for the battery charging test.

Referring to FIGS. 17 and 18, the test jig 1700 includes a first plate 1711, a second plate 1712 and a fastener 1730. The fastener 1730 includes at least one bolt 1731 and at least one nut 1732. The charging test apparatus 100 may perform the above-described intermittent charging process to establish the quick charging protocol of the battery 11 connected to the test jig 1700. In this instance, another charger 3 having the equivalent function to the charger 3 may be used for charge current supply.

The first plate 1711 and the second plate 1712 are positioned on two sides (for example, upper and lower sides) of the battery 11. Each of the first plate 1711 and the second plate 1712 has at least one coupling hole. The thread of the bolt 1731 passes through the coupling hole of the second plate 1712 and the coupling hole of the first plate 1711, and the nut 1732 is rotatably coupled to the end of the thread of the bolt 1731. FIG. 17 shows six bolts and six nuts coupled in a one-to-one relationship. Accordingly, the battery 11 may be tightly secured between the first plate 1711 and the second plate 1712.

The test jig 1700 may further include at least one foam pad 1751, 1752. The foam pad 1751, 1752 may be provided for the purpose of heat insulation in order to prevent the transfer of heat generated from the battery 11 during charging. For example, the test jig 1700 and the battery 11 may be held together by applying pressure to the first plate 1711 and the second plate 1712 from two sides by using the fastener 1730, with the foam pad 1751 interposed between the first plate 1711 and the battery 11, and the foam pad 1752 interposed between the second plate 1712 and the battery 11. Any one of the two foam pads 1751, 1752 may be only interposed between the first plate 1711 or the second plate 1712 and the battery 11, or none of the two foam pads 1751, 1752 may be interposed. When any one of the two foam pads 1751, 1752 is only interposed, heat from the battery 11 may spread more quickly than when both the two foam pads 1751, 1752 are interposed. In addition, when none of the two foam pads 1751, 1752 is interposed, heat from the battery 11 may spread most quickly compared to when any one of the two foam pads 1751, 1752 is only interposed. That is, to determine the depth of charge for each heat generation environment, the heat generation environment during charging of the battery 11 may vary by changing the conditions in which the two foam pads 1751, 1752 are interposed.

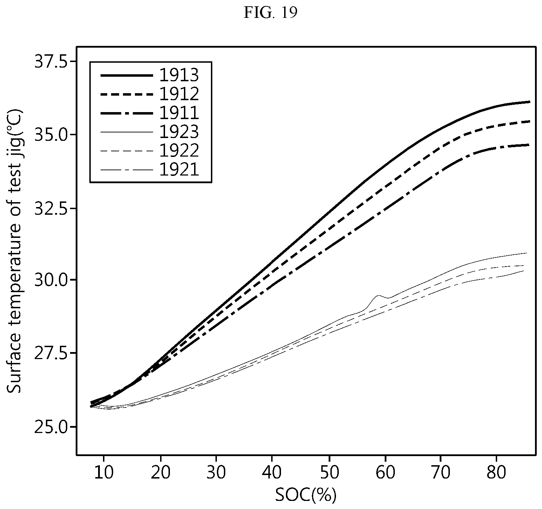

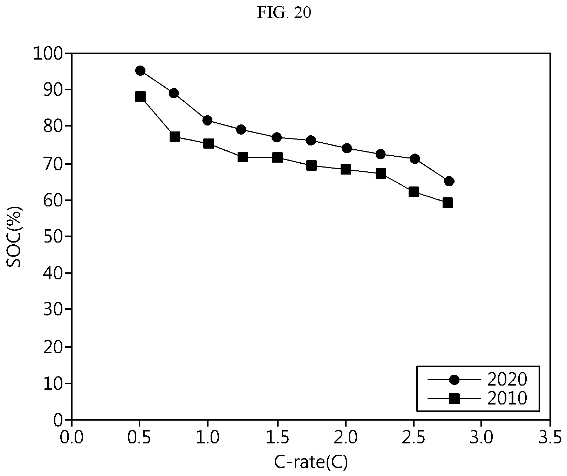

FIGS. 19 and 20 are diagrams referenced in describing the result of the charging test using the test jig shown in FIGS. 17 and 18.

First, referring to FIG. 19, three temperature curves 1911, 1912, 1913 are graphs showing changes in surface temperature of the test jig 1700 as a function of SOC of the battery 11 during charging from SOC 0% to SOC 100% at three C-rates of 2.25C, 2.5C, 2.75C in the battery 11 secured to the test jig 1700 with none of the foam pads 1751, 1752 interposed therebetween. The surface temperature of the test jig 1700 may be measured using a temperature sensor built in the test jig 1700 or disposed within a predetermined distance from the test jig 1700.

The remaining three temperature curves 1921, 1922, 1923 are graphs showing changes in battery temperature as a function of SOC of the battery 11 during charging from SOC 0% to SOC 100% at three C-rates of 2.25C, 2.5C, 2.75C in the battery 11 secured to the test jig 1700 with the two foam pads 1751, 1752 interposed therebetween.

When comparing the temperature curves 1911, 1912, 1913 with the temperature curves 1921, 1922, 1923, it can be seen that the heat generation environment during charging of the battery 11 differs depending on whether the foam pads 1751, 1752 are interposed, creating a temperature difference of approximately 5°C at the later stage of charging.

Subsequently, referring to FIG. 20, each of two SOC curves 2010, 2020 is a graph showing changes in depth of charge acquired through the charging test using each one of a plurality of C-rates selected in a range between 0.5C to 2.75C in a state in which the battery 11 is secured to the test jig 1700.

The SOC curve 2010 shows changes in depth of charge as a function of C-rate when the battery 11 is secured to the test jig 1700 with none of the foam pads 1751, 1752 interposed therebetween.

The SOC curve 2020 shows changes in depth of charge as a function of C-rate when the battery 11 is secured to the test jig 1700 with the two foam pads 1751, 1752 interposed therebetween.

When comparing the two SOC curves 2010, 2020, in the presence of the foam pads 1751, 1752 interposed, heat generated during charging of the battery 11 positioned within the test jig 1700 is insulated by the two foam pads 1751, 1752, so the battery 11 is charged at higher temperature than when the foam pads 1751, 1752 are not interposed. It can be seen that due to the heat insulation effect of the foam pads 1751, 1752 interposed, the increase in surface temperature of the test jig 1700 is approximately 5°C lower than when the foam pads 1751, 1752 are not interposed, whereas the depth of charge is increased.

In contrast, when none of the foam pads 1751, 1752 is interposed, heat generated during charging of the battery 11 transfers to the first plate 1711 and the second plate 1712 and to the outside quickly, so the higher surface temperature of the test jig 1700 is observed than when the foam pads 1751, 1752 are interposed. Accordingly, compared to when the foam pads 1751, 1752 are interposed, the temperature rise caused by the heat generation of the battery 11 is suppressed, and the depth of charge is decreased.

When the charging test procedure described above with reference to FIGS. 1 to 20 is repeatedly performed in the plurality of charging conditions (also referred to as 'charging test conditions'), the plurality of charging test results respectively associated with the plurality of charging conditions may be acquired.

The quick charge map generation apparatus 200 may generate the quick charge map based on the plurality of charging test results through collaboration with the charging test apparatus 100. The quick charge map generation apparatus 200 includes a data input/output unit 210 and a processor 220 as shown in FIG. 1.

The data input/output unit 210 includes at least one of a wired communication interface or a wireless communication interface that can be operably coupled to the charging test apparatus 100.

The processor 220 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing other functions.

A memory built in the processor 220 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory may store data and programs required for the operation by the processor 220. The memory may store data indicating the results of the operation by the processor 220.

Meanwhile, the method for acquiring the plurality of charging test results used to generate the quick charge map as described below is not limited to the method described above with reference to FIGS. 1 to 20. That is, any method that provides information about the depth of charge and the battery temperature for each arbitrary charging condition may be used to acquire the charging test results for the generation of the quick charge map.

FIG. 21 is a 3D graph exemplarily showing the plurality of charging test results according to the plurality of charging conditions.

Referring to FIG. 21, a total of 42 data points (charging test results) are shown, respectively corresponding to a total of 42 charging conditions by a combination of a total of six C-rates (may be indicated by signs of C1 to C6 in a sequential order) spaced at 0.5C interval in a range between 0.5C and 3.0C and a total of seven ambient temperatures (may be indicated by signs of T1 to T7 in a sequential order) spaced at 5°C interval in a range between 15°C and 45°C.

The highest C-rate of the plurality of charging conditions may be equal to or less than the upper limit of a predetermined allowable current range, and the lowest C-rate of the plurality of charging conditions may be equal to or greater than the lower limit of the allowable current range.

The highest ambient temperature of the plurality of charging conditions may be equal to or less than the upper limit of a predetermined allowable temperature range, and the lowest ambient temperature of the plurality of charging conditions may be equal to or greater than the lower limit of the allowable temperature range.

A data point associated with any charging condition may indicate a pair of depth of charge and battery temperature (cell temperature) according to the charging condition.

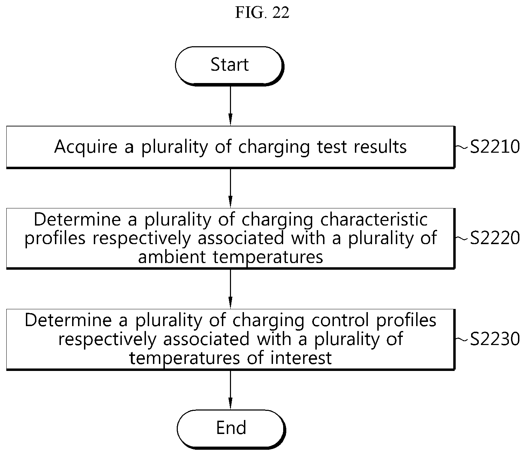

FIG. 22 is a flowchart referenced in describing the method for generating the quick charge map according to an embodiment of the present disclosure by way of illustration.

Referring to FIG. 22, in step S2210, the data input/output unit 210 acquires, from the charging test apparatus 100, the plurality of charging test results (see the data points of FIG. 21) respectively associated with the plurality of charging conditions. A set of the plurality of charging test results acquired from the charging test apparatus 100 may be referred to as 'charging test result information'.

In step S2220, the processor 220 may determine a plurality of charging characteristic profiles respectively associated with the plurality of ambient temperatures used as the charging conditions by analyzing the plurality of charging test results acquired in the step S2210.

In step S2230, the processor 220 determines a plurality of charging control profiles respectively associated with a plurality of temperatures of interest by analyzing the plurality of charging characteristic profiles determined in the step S2220. The plurality of temperatures of interest may be preset in view of a preset optimal usage temperature range for the battery.

The plurality of charging control profiles determined in the step S2230 may be recorded in the memory of the processor 220, and in the present disclosure, the 'quick charge map' may refer to a set of the plurality of charging control profiles. The processor 220 may share the quick charge map (QCM) (see FIG. 29) with the charging test apparatus 100 through the data input/output unit 210.

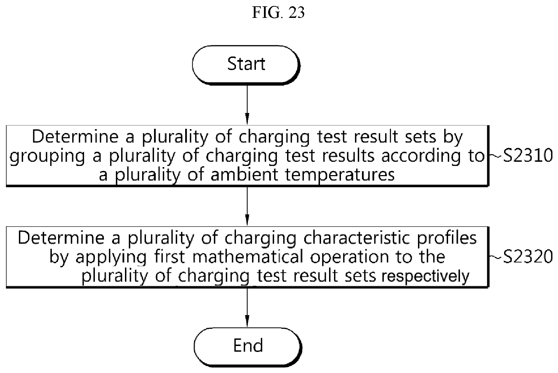

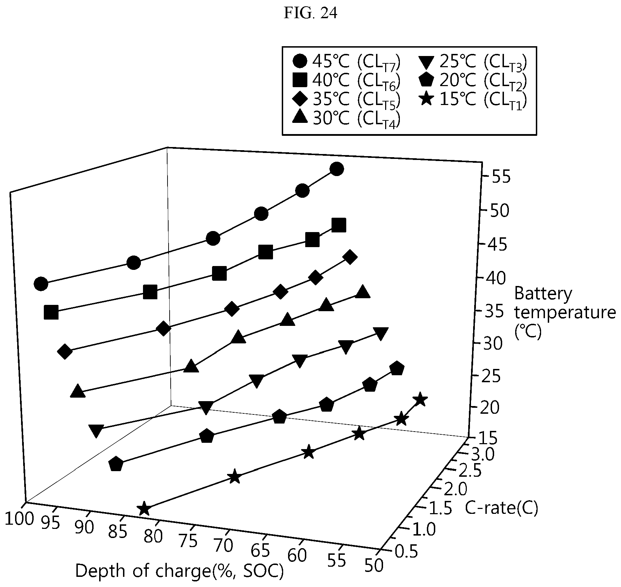

FIG. 23 is a flowchart referenced in describing an example of subroutines that may be included in the step S2220 of FIG. 22 by way of illustration, and FIG. 24 is a graph referenced in describing the method of FIG. 23.

Referring to FIG. 23, in step S2310, the processor 220 determines a plurality of charging test result sets by grouping the plurality of charging test results according to the plurality of ambient temperatures used as the charging conditions. That is, the plurality of charging test results may be grouped such that the charging test results associated with the charging conditions having the same ambient temperature belong to the same group. For example, the charging test results indicated by the same symbol in FIG. 21 may be classified into a common group. Accordingly, the number of charging test result sets determined in the step S2310 may be equal to the number of ambient temperature values used as the charging conditions.

In the step S2320, the processor 220 determines the plurality of charging characteristic profiles respectively associated with the plurality of C-rates by applying a first mathematical operation to the plurality of charging test result sets, respectively. The first mathematical operation may be curve fitting based on a polynomial having a predetermined highest degree.

The charging characteristic profile associated with the specific ambient temperature may represent a 3D relationship characteristic between the C-rate, the depth of charge and the battery temperature of the battery 11 according to the ambient temperature.

FIG. 24 shows seven charging characteristic profiles $CL_{T1} \sim CL_{T7}$ respectively associated with seven ambient temperatures T1~T7.

The processor 220 may determine a battery temperature range for each charging characteristic profile. The battery temperature range of any charging characteristic profile may be defined by the lowest battery temperature and the highest battery temperature of the charging characteristic profile. The lowest battery temperature and the highest battery temperature of the charging characteristic profile may be equal to the battery temperatures at two end points. For example, in FIG. 24, the battery temperature at one end point of the charging characteristic profile $CL_{T1}$ may be 15°C that is equal to the ambient temperature T1, and the battery temperature at the other end point of the charging characteristic profile $CL_{T1}$ may be 22°C, and in this case, the battery temperature range of the charging characteristic profile $CL_{T1}$ may range from 15°C to 22°C.

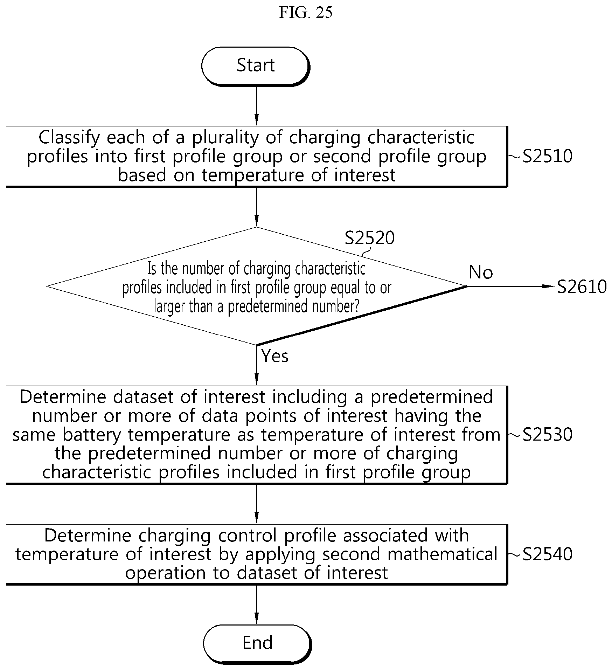

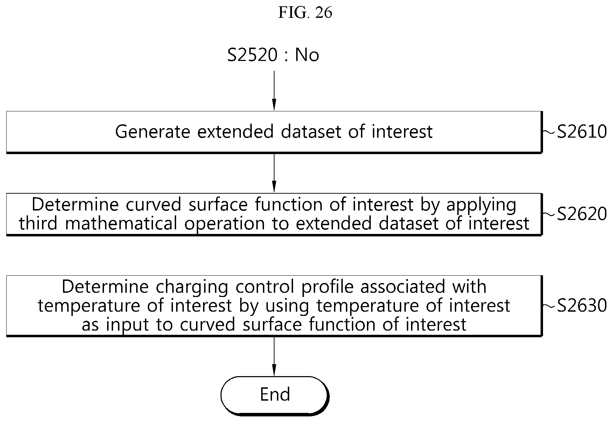

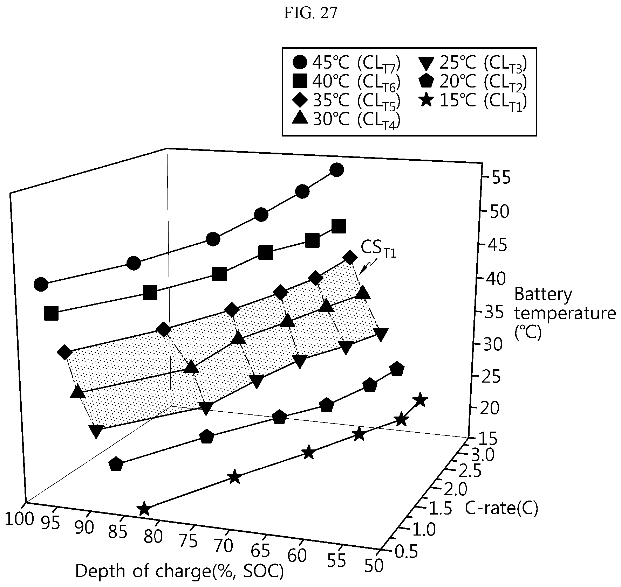

FIGS. 25 and 26 are flowcharts referenced in describing an example of subroutines that may be included in the step S2230 of FIG. 22 by way of illustration, and FIGS. 27 to 29 are graphs referenced in describing the method of FIGS. 25 and 26. The method according to FIGS. 25 and 26 may be performed for each of a plurality of preset temperatures of interest. In describing the method according to FIGS. 25 and 26, reference may be made to FIG. 24 again.

First, referring to FIG. 25, in step S2510, the processor 220 classifies each of the plurality of charging characteristic profiles $CL_{T1} \sim CL_{T7}$ into a first profile group or a second profile group based on the temperature of interest. Specifically, each charging characteristic profile having the battery temperature range to which the temperature of interest belongs among the plurality of charging characteristic profiles $CL_{T1} \sim CL_{T7}$ may be classified into the first profile group, and each of the other charging characteristic profiles may be classified into the second profile group. For example, where the temperature of interest = 35°C, the charging characteristic profiles $CL_{T4}$, $CL_{T5}$ in FIG. 24 may be classified into the first profile group, and the remaining charging characteristic profiles $CL_{T1} \sim CL_{T3}$, $CL_{T6}$, $CL_{T7}$ may be classified into the second profile group.

In step S2520, the processor 220 determines whether the number of charging characteristic profiles included in the first profile group is equal to or larger than a predetermined number. Here, the predetermined number may be equal to or larger than the highest order of the second mathematical operation used in step S2540 as described below. When a value of the step S2520 is "Yes", step S2530 may be performed. When the value of the step S2520 is "No", the method according to FIG.

25 may end or move to step S2610. Referring back to FIG. 24, for example, when the temperature of interest is 35°C and the predetermined number is equal to or larger than 3, only the two charging characteristic profiles $CL_{T4}$, $CL_{T5}$ are classified into the first profile group, therefore the value of the step S2520 is "No".

In the step S2530, the processor 220 determines a dataset of interest including a predetermined number or more of data points of interest having the same battery temperature as the temperature of interest from the predetermined number or more of charging characteristic profiles in the first profile group. In each charging characteristic profile of the first profile group, the temperature of interest belongs to the battery temperature range. Accordingly, the same number of data points of interest as the total number of charging characteristic profiles included in the first profile group may be determined in the step S2530.

In the step S2540, the processor 220 determines the charging control profile associated with the temperature of interest by applying the second mathematical operation to the dataset of interest determined in the step S2530. The second mathematical operation may be curve fitting based on a polynomial having a predetermined highest degree. The highest degree of the second mathematical operation may be equal to or larger than 2, and the highest degree of the first mathematical operation and the highest degree of the second mathematical operation may be equal or different from each other.

Subsequently, referring to FIG. 26, in step S2610, the processor 220 generates an extended dataset of interest including the charging test results of each charging characteristic profile having the battery temperature range to which the temperature of interest belongs and the charging test results of at least one charging characteristic profile having the battery temperature range to which the temperature of interest does not belong. That is, the extended dataset of interest may include the dataset of interest including the charging test results of less than the predetermined number of charging characteristic profiles classified into the first profile group, with an addition of the charging test results of at least one charging characteristic profile classified into the second profile group. For example, when the temperature of interest is 35°C, the extended dataset of interest includes twelve charging test results of two charging characteristic profiles $CL_{T4}$, $CL_{T5}$ in the first profile group, and further includes the charging test results of at least one charging characteristic profile (for example, $CL_{T3}$) of the remaining charging characteristic profiles $CL_{T1}$~$CL_{T3}$, $CL_{T6}$, $CL_{T7}$.

The processor 220 may determine a first reference temperature and a second reference temperature of the dataset of interest associated with the charging characteristic profiles of the first profile group. The first reference temperature may be the highest battery temperature associated with the lowest C-rate C 1, and the second reference temperature may be the lowest battery temperature associated with the highest C-rate C7.

When the first reference temperature is lower than the temperature of interest, the processor 220 may select, from the second profile group, at least one charging characteristic profile in which the battery temperature associated with the lowest C-rate C1 is equal to or higher than the temperature of interest.

When the second reference temperature is higher than the temperature of interest, the processor 220 may select, from the second profile group, at least one charging characteristic profile in which the battery temperature associated with the highest C-rate C7 is equal to or lower than the temperature of interest.

Referring to FIG. 27, for example, because the first profile group includes the two charging characteristic profiles $CL_{T4}$, $CL_{T5}$, the first reference temperature of the first profile group is the battery temperature of 35°C associated with the C-rate C1 of the charging characteristic profile $CL_{T5}$, and the second reference temperature of the first profile group is the battery temperature of 37°C associated with the C-rate C7 of the charging characteristic profile $CL_{T4}$. When it is assumed that the temperature of interest is 35°C, the first reference temperature of 35°C is equal to the temperature of interest, and the second reference temperature of 37°C is higher than the temperature of interest. Accordingly, the processor 220 may determine the extended dataset of interest by selecting the charging characteristic profile $CL_{T3}$ from the second profile group and adding the charging test result (i.e., six data points) of the selected charging characteristic profile $CL_{T3}$ to the dataset of interest.

In step S2620, the processor 220 determines a curved surface function of interest by applying a third mathematical operation to the extended dataset of interest. The third mathematical operation may include known curved surface fitting logic. The 3D area $CS_{TI}$ indicated by shading in FIG. 27 is an example of 3D surface fitted to the extended dataset of interest, and the curved surface function of interest represents the 3D surface.

In step S2630, the processor 220 determines the charging control profile associated with the temperature of interest by using the temperature of interest as input to the curved surface function of interest. Because the curved surface function of interest represents the 3D relationship between the depth of charge, the C-rate and the battery temperature, when the temperature of interest is determined, the curved surface function of interest may be simplified to the charging control profile representing a 2D relationship between the C-rate and the battery temperature.

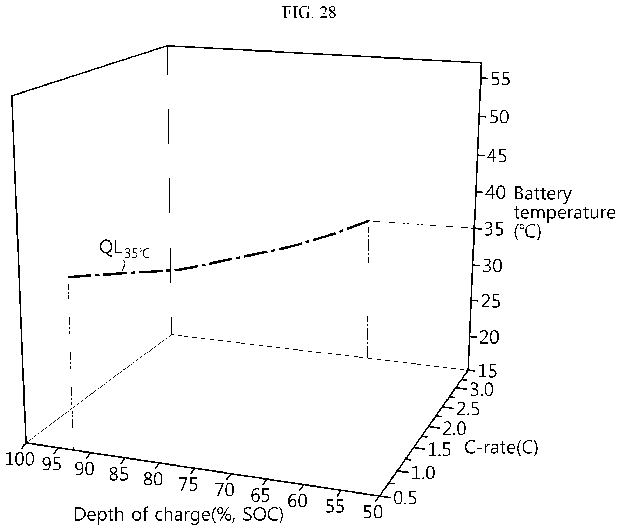

FIG. 28 shows an example of the charging control profile $QL_{35°C}$ acquired by determining the battery temperature of the curved surface function of interest corresponding to the 3D curve $CS_{TI}$ of FIG. 27 as 35°C that is equal to the temperature of interest.

FIG. 29 shows the charging control profile $QL_{35°C}$ of FIG. 28 and charging control profiles $QL_{25°C}$,

$QL_{45°C}$ for two additional temperatures of interest, 25°C and 45°C. The quick charge map (QCM) may be a set of the charging control profiles $QL_{25°C}$, $QL_{35°C}$, $QL_{45°C}$ individually associated with all the temperatures of interest. The quick charge map (QCM) may be stored in the battery management system mounted on an electric vehicle, and in this case, the battery management system may control the quick charging procedure for the battery cell BC provided as a power source for the electric vehicle using the quick charge map (QCM).

The charging control method of the battery cell BC based on the quick charge map (QCM) that may be performed by the battery management system will be briefly described with reference to FIG. 29 below.

During charging of the battery cell BC, the temperature of the battery cell BC may be monitored in real time. For example, in response to the temperature of the battery cell BC during charging being monitored as 35°C, the specific depth of charge associated with the C-rate corresponding to the charge current flowing through the battery cell BC may be identified from the charging control profile $QL_{35°C}$ of the quick charge map (QCM). When the SOC of the battery cell BC is equal to or more than the identified depth of charge, the battery management system may immediately take a control action by stopping the charging of the battery cell BC or reducing the C-rate of the charge current (for example, changing from C3 to C2).

Although the present disclosure has been hereinabove described with regard to certain embodiments and drawings, the present disclosure is not limited thereto and it is obvious to those skilled in the art that various modifications and changes may be made thereto within the technical aspects of the present disclosure and the scope of the appended claims and their equivalents.

Additionally, as many substitutions, modifications and changes may be made to the present disclosure as described above by those skilled in the art without departing from the technical aspects of the present disclosure, the present disclosure is not limited by the above-described embodiments and the accompanying drawings, and some or all of the embodiments may be selectively combined to allow various modifications.

**Claims**

1. A method for generating a quick charge map comprising:

    acquiring a plurality of charging test results respectively associated with a plurality of charging conditions according to a combination of a plurality of current rates and a plurality of ambient temperatures;
    determining a plurality of charging characteristic profiles respectively associated with the plurality of ambient temperatures by analyzing the plurality of charging test results; and
    determining a plurality of charging control profiles respectively associated with a plurality of temperatures of interest by analyzing the plurality of charging characteristic profiles, wherein the quick charge map is a set of the plurality of charging control profiles.

2. The method for generating the quick charge map according to claim 1,

    wherein a lowest ambient temperature of the plurality of ambient temperatures is equal to or greater than a lower limit of a predetermined allowable temperature range,
    wherein a highest ambient temperature of the plurality of ambient temperatures is equal to or less than an upper limit of the allowable temperature range,
    wherein a lowest current rate of the plurality of current rates is equal to or greater than a lower limit of a predetermined allowable current range, and
    wherein a highest current rate of the plurality of current rates is equal to or less than an upper limit of the allowable current range.

3. The method for generating the quick charge map according to claim 1,

    wherein each of the plurality of charging test results indicates a depth of charge and a battery temperature of a battery when charging the battery in any one of the plurality of charging conditions,
    wherein the depth of charge of each of the plurality of charging test results indicates a maximum state of charge (SOC) of the battery at which the battery can be charged without lithium plating, and
    wherein the battery temperature of each of the plurality of charging test results indicates a temperature of the battery at a timing corresponding to the depth of charge.

4. The method for generating the quick charge map according to claim 1,
    wherein the determining of the plurality of charging characteristic profiles comprises:

    determining a plurality of charging test result sets by grouping the plurality of charging test results according to the plurality of ambient temperatures; and
    determining the plurality of charging characteristic profiles by applying a mathematical operation to the plurality of charging test result sets, respectively.

5. The method for generating the quick charge map according to claim **4,**
wherein the mathematical operation is curve fitting based on a polynomial having a predetermined highest degree.

6. The method for generating the quick charge map according to claim 1,
wherein each of the plurality of charging characteristic profiles indicates a three-dimensional relationship between a current rate, a depth of charge and a battery temperature according to any one of the plurality of ambient temperatures.

7. The method for generating the quick charge map according to claim 1,
wherein the determining of the plurality of charging control profiles comprises performing on the plurality of temperatures of interest, respectively, following steps of:

> determining, when the plurality of charging characteristic profiles includes a predetermined number or more of charging characteristic profiles having a battery temperature range to which the temperature of interest belongs, a dataset of interest including the predetermined number or more of data points of interest having a same battery temperature as the temperature of interest from the predetermined number or more of charging characteristic profiles; and determining the charging control profile associated with the temperature of interest by applying a mathematical operation to the dataset of interest.

8. The method for generating the quick charge map according to claim 7,
wherein the mathematical operation is curve fitting based on a polynomial having a predetermined highest degree.

9. The method for generating the quick charge map according to claim 1,
wherein the determining of the plurality of charging control profiles comprises performing on the plurality of temperatures of interest, respectively, following steps of:

> determining, when the plurality of charging characteristic profiles includes less than a predetermined number of charging characteristic profiles having a battery temperature range to which the temperature of interest belongs, a curved surface function of interest by applying a mathematical operation to an extended dataset of interest including the charging test results of each charging characteristic profile having the battery temperature range to which the temperature of interest belongs and the charging test results of at least one charging characteristic profile having a battery temperature range to which the temperature of interest does not belong; and determining the charging control profile associated with the temperature of interest by using the temperature of interest as input to the curved surface function of interest.

10. The method for generating the quick charge map according to claim 1,
wherein each of the plurality of charging control profiles indicates a relationship between a current rate and a depth of charge according to any one of the plurality of temperatures of interest.

11. An apparatus for generating a quick charge map comprising:

> a data input/output unit to acquire a plurality of charging test results respectively associated with a plurality of charging conditions according to a combination of a plurality of current rates and a plurality of ambient temperatures; and a processor to determine a plurality of charging characteristic profiles respectively associated with the plurality of ambient temperatures by analyzing the plurality of charging test results, wherein the processor is configured to: determine a plurality of charging control profiles respectively associated with a plurality of temperatures of interest by analyzing the plurality of charging characteristic profiles, wherein the quick charge map is a set of the plurality of charging control profiles.

12. The apparatus for generating the quick charge map according to claim 11,
wherein the processor is configured to:

> determine a plurality of charging test result sets by grouping the plurality of charging test results according to the plurality of ambient temperatures; and determine the plurality of charging characteristic profiles by applying a mathematical operation to the plurality of charging test result sets, respectively.

13. The apparatus for generating the quick charge map according to claim 11,
wherein the processor is configured to:

> determine the plurality of charging control profiles by performing a procedure on the plurality of temperatures of interest, respectively, the procedure including operations of:

determining, when the plurality of charging characteristic profiles includes a predetermined number or more of charging characteristic profiles having a battery temperature range to which the temperature of interest belongs, a dataset of interest including the predetermined number or more of data points of interest having a same battery temperature as the temperature of interest from the predetermined number or more of charging characteristic profiles; and determining the charging control profile associated with the temperature of interest by applying a mathematical operation to the dataset of interest.

14. The apparatus for generating the quick charge map according to claim 11,
   wherein the processor is configured to:

   determine the plurality of charging control profiles by performing a procedure on the plurality of temperatures of interest, respectively, the procedure including operations of:
   determining, when the plurality of charging characteristic profiles includes less than a predetermined number of charging characteristic profiles having a battery temperature range to which the temperature of interest belongs, a curved surface function of interest by applying a mathematical operation to an extended dataset of interest including the charging test results of each charging characteristic profile having the battery temperature range to which the temperature of interest belongs and the charging test results of at least one charging characteristic profile having a battery temperature range to which the temperature of interest does not belong; and determining the charging control profile associated with the temperature of interest by using the temperature of interest as input to the curved surface function of interest.

15. A charging system comprising the apparatus for generating the quick charge map according to any one of claims 11 to 14.

FIG. 1

EP 4 765 564 A1

FIG. 2a

```
                        ┌─────────────┐
                        │    Start    │
                        └─────────────┘
                               │
    ┌──────────────────────────┼──────────────────────────┐
    │  ┌──────────────────────────────────────────────┐    │
    │  │      Control charger into charge mode        │~S210
    │  └──────────────────────────────────────────────┘
    │         S220                  │ ◄─────────────────────┐
    │          ┌────────────────────────────────────┐  No   │
    │          │   Is first switching condition met? ├──────┘
    │          └────────────────────────────────────┘
    │                              │ Yes
    │  ┌──────────────────────────────────────────────┐
    │  │       Control charger into rest mode         │~S230
    │  └──────────────────────────────────────────────┘
    │         S240                  │ ◄─────────────────────┐
    │          ┌────────────────────────────────────┐  No   │
    │          │  Is second switching condition met? ├──────┘
    │          └────────────────────────────────────┘
    │                              │ Yes        S242
    │   No  ┌────────────────────────────────────┐
    └───────┤  Did SOC of battery cell reach end  │
            │           of charge SOC?            │
            └────────────────────────────────────┘
                               │ Yes
                        ┌─────────────┐
                        │     End     │
                        └─────────────┘
```

FIG. 2b

```
          ┌─────────────┐
          │    Start    │
          └──────┬──────┘
                 │
                 ▼
  ┌───────────────────────────────────────────┐
  │ Calculate internal resistance based on    │ ~S250
  │ amount of voltage change of battery cell  │
  │ in resting period                         │
  └───────────────────┬───────────────────────┘
                      │
                      ▼
  ┌───────────────────────────────────────────┐
  │ Associate internal resistance with SOC of │ ~S260
  │ battery cell and record it                │
  └───────────────────┬───────────────────────┘
                      │
                      ▼
          ┌─────────────┐
          │     End     │
          └─────────────┘
```

FIG. 3

FIG. 4

FIG. 5

FIG. 6

FIG. 7

FIG. 8

```
                    ╭──────────╮
                    │  Start   │
                    ╰────┬─────╯
                         │
                         ▼
┌─────────────────────────────────────────────────┐
│ Generate resistance curve by polynomial fitting  │  ~S810
│         of resistance time-series dataset        │
└─────────────────────────────────────────────────┘
                         │
                         ▼
┌─────────────────────────────────────────────────┐
│ Determine depth of charge by analyzing pattern   │  ~S820
│               of resistance curve                │
└─────────────────────────────────────────────────┘
                         │
                         ▼
                    ╭──────────╮
                    │   End    │
                    ╰──────────╯
```

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

```
                    ┌─────────────┐
                    │    Start    │
                    └──────┬──────┘
                           │
                           ▼
┌──────────────────────────────────────────────┐
│   Acquire a plurality of charging test results │  ~S2210
└──────────────────────┬─────────────────────────┘
                       │
                       ▼
┌──────────────────────────────────────────────┐
│  Determine a plurality of charging characteristic │
│  profiles respectively associated with a plurality of │  ~S2220
│             ambient temperatures              │
└──────────────────────┬─────────────────────────┘
                       │
                       ▼
┌──────────────────────────────────────────────┐
│  Determine a plurality of charging control profiles │
│    respectively associated with a plurality of  │  ~S2230
│            temperatures of interest            │
└──────────────────────┬─────────────────────────┘
                       │
                       ▼
                ┌─────────────┐
                │     End     │
                └─────────────┘
```

FIG. 23

Start

Determine a plurality of charging test result sets by grouping a plurality of charging test results according to a plurality of ambient temperatures ~S2310

Determine a plurality of charging characteristic profiles by applying first mathematical operation to the plurality of charging test result sets respectively ~S2320

End

FIG. 24

FIG. 25

```
                    ┌─────────────┐
                    │    Start    │
                    └─────────────┘
                           │
                           ▼
    ┌──────────────────────────────────────────────┐
    │  Classify each of a plurality of charging     │
    │  characteristic profiles into first profile   │~S2510
    │  group or second profile group based on       │
    │  temperature of interest                      │
    └──────────────────────────────────────────────┘
                           │
                           ▼                    S2520
                    ╱──────────────────╲
                   ╱  Is the number of   ╲
                  ╱ charging characteristic╲      No
    ╱─────────────  profiles included in first ─────────────────►  S2610
    ╲             ╲ profile group equal to or ╱
                   ╲ larger than a predetermined╱
                    ╲    number?       ╱
                     ╲───────────────╱
                           │ Yes
                           ▼
    ┌──────────────────────────────────────────────┐
    │  Determine dataset of interest including a    │
    │  predetermined number or more of data points  │
    │  of interest having the same battery          │~S2530
    │  temperature as temperature of interest from  │
    │  the predetermined number or more of charging │
    │  characteristic profiles included in first    │
    │  profile group                                │
    └──────────────────────────────────────────────┘
                           │
                           ▼
    ┌──────────────────────────────────────────────┐
    │  Determine charging control profile           │
    │  associated with temperature of interest by   │~S2540
    │  applying second mathematical operation to    │
    │  dataset of interest                          │
    └──────────────────────────────────────────────┘
                           │
                           ▼
                    ┌─────────────┐
                    │     End     │
                    └─────────────┘
```

FIG. 26

S2520 : No

Generate extended dataset of interest ~S2610

Determine curved surface function of interest by applying
third mathematical operation to extended dataset of interest ~S2620

Determine charging control profile associated with
temperature of interest by using temperature of interest
as input to curved surface function of interest ~S2630

End

FIG. 27

FIG. 28

FIG. 29

## INTERNATIONAL SEARCH REPORT

| International application No. |
|---|
| **PCT/KR2025/006888** |

| A. | CLASSIFICATION OF SUBJECT MATTER |
|---|---|

**H02J 7/00**(2006.01)i; **G01R 31/382**(2019.01)i; **G01R 31/392**(2019.01)i; **G01R 31/396**(2019.01)i

According to International Patent Classification (IPC) or to both national classification and IPC

| B. | FIELDS SEARCHED |
|---|---|

Minimum documentation searched (classification system followed by classification symbols)

H02J 7/00(2006.01); B60L 53/10(2019.01); B60L 53/62(2019.01); G01R 31/36(2006.01); G01R 31/3835(2019.01); G01R 31/389(2019.01); H01M 10/44(2006.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 급속(quick), 충전 맵(charge map), 온도(temperature), 전류 레이트(current rate), 프로파일(profile)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2022-0083149 A (RENAULT KOREA MOTORS CO., LTD.) 20 June 2022 (2022-06-20)<br>see paragraphs [0036]-[0053]; claim 1; and figures 4-5. | 1-15 |
| A | KR 10-2018-0056238 A (SAMSUNG ELECTRONICS CO., LTD.) 28 May 2018 (2018-05-28)<br>see paragraphs [0031]-[0047]; claim 1; and figure 1. | 1-15 |
| A | KR 10-2024-0066905 A (LG ENERGY SOLUTION, LTD.) 16 May 2024 (2024-05-16)<br>see paragraphs [0039]-[0069]; and figures 1-2. | 1-15 |
| A | US 2022-0134900 A1 (GM GLOBAL TECHNOLOGY OPERATIONS LLC) 05 May 2022 (2022-05-05)<br>see paragraphs [0034]-[0064]; and figures 1-4. | 1-15 |
| A | JP 2018-523891 A (LG CHEM, LTD.) 23 August 2018 (2018-08-23)<br>see paragraphs [0032]-[0076]; and figures 1-2. | 1-15 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **28 August 2025** | **29 August 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2025/006888**

| Patent document cited in search report | | | Publication date (day/month/year) | Patent family member(s) | | | Publication date (day/month/year) |
|---|---|---|---|---|---|---|---|
| KR | 10-2022-0083149 | A | 20 June 2022 | None | | | |
| KR | 10-2018-0056238 | A | 28 May 2018 | CN | 108075200 | A | 25 May 2018 |
| | | | | CN | 108075200 | B | 17 May 2022 |
| | | | | EP | 3331124 | A1 | 06 June 2018 |
| | | | | EP | 3331124 | B1 | 14 August 2019 |
| | | | | JP | 2018-082618 | A | 24 May 2018 |
| | | | | JP | 7015678 | B2 | 03 February 2022 |
| | | | | KR | 10-2695516 | B1 | 14 August 2024 |
| | | | | US | 10566818 | B2 | 18 February 2020 |
| | | | | US | 2018-0145531 | A1 | 24 May 2018 |
| KR | 10-2024-0066905 | A | 16 May 2024 | CN | 118613986 | A | 06 September 2024 |
| | | | | EP | 4472015 | A1 | 04 December 2024 |
| | | | | EP | 4472015 | A4 | 02 July 2025 |
| | | | | KR | 10-2767066 | B1 | 11 February 2025 |
| | | | | WO | 2024-101832 | A1 | 16 May 2024 |
| US | 2022-0134900 | A1 | 05 May 2022 | CN | 114430186 | A | 03 May 2022 |
| | | | | DE | 102021111131 | A1 | 05 May 2022 |
| | | | | US | 11691531 | B2 | 04 July 2023 |
| JP | 2018-523891 | A | 23 August 2018 | CN | 107408827 | A | 28 November 2017 |
| | | | | CN | 107408827 | B | 21 April 2020 |
| | | | | EP | 3252918 | A1 | 06 December 2017 |
| | | | | EP | 3252918 | A4 | 13 June 2018 |
| | | | | EP | 3252918 | B1 | 02 October 2019 |
| | | | | JP | 6454817 | B2 | 16 January 2019 |
| | | | | KR | 10-1925002 | B1 | 04 December 2018 |
| | | | | KR | 10-2017-0022758 | A | 02 March 2017 |
| | | | | US | 10333180 | B2 | 25 June 2019 |
| | | | | US | 2018-0069272 | A1 | 08 March 2018 |
| | | | | WO | 2017-034275 | A1 | 02 March 2017 |

Form PCT/ISA/210 (patent family annex) (July 2022)

**REFERENCES CITED IN THE DESCRIPTION**

**Patent documents cited in the description**

• KR 1020240073265